# EUROPEAN PATENT APPLICATION

(11) **EP 4 658 015 A1**
(43) Date of publication of application: **03.12.2025**
(21) Application number: 23946980.2
(22) Date of filing: 28.07.2023
(51) Int. Cl.: H10B 43/50, H01L 21/768

(54) **SEMICONDUCTOR STRUCTURE AND MANUFACTURING METHOD THEREFOR, AND MEMORY SYSTEM**

(71) Applicant: Yangtze Memory Technologies Co., Ltd., Wuhan, Hubei 430000 (CN)
(72) Inventor: ZHANG, Zhong, Wuhan, Hubei 430000 (CN); WANG, Di, Wuhan, Hubei 430000 (CN); ZHOU, Wenxi, Wuhan, Hubei 430000 (CN)
(74) Representative: Lippert Stachow Patentanwälte Rechtsanwälte
(86) International application number: PCT/CN2023/110045
(87) International publication number: WO 2025/025024

(57) **Abstract**

The present application provides a semiconductor structure and a manufacturing method thereof, and a memory system. The semiconductor structure includes: a stack structure including a first region, a second region and a boundary region between the first region and the second region, wherein the stack structure includes gate layers and insulation layers stacked alternately, and the gate layers include a first gate layer and a plurality of second gate layers on a side of the first gate layer; a first contact structure in the boundary region, extending and connected to the first gate layer; and a plurality of second contact structures in the second region, extending and connected to the second gate layers of different layers respectively, wherein a size of the first contact structure perpendicular to a stacking direction of the stack structure is different from sizes of the second contact structures perpendicular to the stacking direction.

## Description

### TECHNICAL FIELD

The present application relates to, but is not limited to, a semiconductor structure and a manufacturing method thereof and a memory system.

### BACKGROUND

In order to increase storage density of two-dimensional memories, the existing technology has mass-produced three-dimensional memories such as three-dimensional (3D) NAND, etc. The three-dimensional memory comprises a core area having a memory string channel structure and a step area for leading out a gate of the memory string channel structure, wherein the core area comprises insulation layers and gate layers that are stacked alternately, and the step area comprises contacts (CT) for leading out the gate layers.

With the increase of the number of stack layers of the three-dimensional memory, etching depth of contact vias for forming the contacts is increased accordingly, which proposes higher requirements for the etching process of the contact vias.

### SUMMARY

According to a first aspect of the present application, a semiconductor structure is provided, comprising: a stack structure comprising a first region, a second region and a boundary region between the first region and the second region, wherein the stack structure comprises gate layers and insulation layers that are stacked alternately, and the gate layers include a first gate layer and a plurality of second gate layers on a side of the first gate layer; a first contact structure in the boundary region, extending and connected to the first gate layer; and a plurality of second contact structures in the second region, extending and connected to the second gate layers of different layers respectively, wherein a size of the first contact structure in a direction perpendicular to a stacking direction of the stack structure is different from sizes of the second contact structures in the direction perpendicular to the stacking direction.

According to a second aspect of the present application, a manufacturing method of a semiconductor structure is provided, comprising: forming a stack structure comprising a first region, a second region and a boundary region between the first region and the second region, wherein the stack structure comprises gate layers and insulation layers that are stacked alternately, and the gate layers include a first gate layer and a plurality of second gate layers on a side of the first gate layer; forming a first contact structure in the boundary region by using a first process, the first contact structure extending and connecting to the first gate layer; and forming a plurality of second contact structures in the second region by using a second process, the plurality of second contact structures extending and connecting to the second gate layers of different layers respectively, wherein the first process is different from the second process.

According to a third aspect of the present application, a memory system is provided, comprising: a semiconductor structure that is the semiconductor structure in the above solution; and a controller connected with the semiconductor structure.

### BRIEF DESCRIPTION OF THE DRAWINGS

FIG. 1 is a schematic diagram of an X-Y plane of a first semiconductor structure provided in examples of the present application;
FIG. 2A is a schematic diagram of a Y-Z cross-section of a first region of the semiconductor structure of FIG. 1;
FIG. 2B is a schematic diagram of a B-B cross-section of a boundary region of the semiconductor structure of FIG. 1;
FIG. 2C is a schematic diagram of a C-C cross-section of a second region of the semiconductor structure of FIG. 1;
FIG. 2D is a schematic diagram of a D-D cross-section of a second region of the semiconductor structure of FIG. 1;
FIG. 2E is a schematic diagram of a Y-Z cross-section of a first region of a second semiconductor structure provided in examples of the present application;
FIG. 2F is a schematic diagram of a Y-Z cross-section of a first region of a third semiconductor structure provided in examples of the present application;
FIG. 3 is a schematic diagram of an X-Y plane of a fourth semiconductor structure provided in examples of the present application;
FIG. 4 is a schematic diagram of a B-B cross-section of a boundary region of the semiconductor structure of FIG. 3;
FIG. 5 is a flow diagram of a manufacturing method of a semiconductor structure provided by examples of the present application;
FIGs. 6A to 6E are schematic diagrams of an X-Y plane of a manufacturing process of a stack structure of the first semiconductor structure provided by examples of the present application;
FIGs. 7A to 7E are schematic diagrams of an X-Y plane of a manufacturing process of a stack structure of the second semiconductor structure provided by examples of the present application;
FIG. 8A is a schematic diagram of a Y-Z cross-section of a first region of the semiconductor structure of FIG. 6A;
FIG. 8B is a schematic diagram of a B-B cross-section of a boundary region of the semiconductor structure of FIG. 6A;
FIG. 8C is a schematic diagram of a C-C cross-section of a second region of the semiconductor structure of FIG. 6A;
FIG. 8D is a schematic diagram of a D-D cross-section of a second region of the semiconductor structure of FIG. 6A;
FIG. 9A is a schematic diagram of a Y-Z cross-section of a first region of the semiconductor structure of FIG. 6E;
FIG. 9B is a schematic diagram of a B-B cross-section of a boundary region of the semiconductor structure of FIG. 6E;
FIG. 9C is a schematic diagram of a C-C cross-section of a second region of the semiconductor structure of FIG. 6E;
FIG. 9D is a schematic diagram of a D-D cross-section of a second region of the semiconductor structure of FIG. 6E;
FIG. 10 is a schematic diagram of a B-B cross-section of a boundary region of the semiconductor structure of FIG. 7E;
FIGs. 11A to 11F are schematic cross-sectional views of a manufacturing process of a second contact structure of the third semiconductor structure provided by examples of the present application;
FIG. 12 is a schematic diagram of an example system having a memory system according to an example of the present application;
FIG. 13 is a schematic diagram of an example memory card having a memory system according to an example of the present application; and
FIG. 14 is a schematic diagram of an example solid-state drive having a memory system according to an example of the present application.

In the above drawings, which are not necessarily drawn to scale, like reference numerals may describe like components in different views. Like reference numerals having different letter suffixes may represent different examples of like components. Various examples as discussed herein are generally illustrated by the drawings by means of examples, but not by means of limitations.

### DETAILED DESCRIPTION

In order to make technical solutions and advantages of examples of the present application clearer, the technical solutions of the present application will be further described below in detail in conjunction with the drawings and examples. Although example implementation methods of the present application are shown in the drawings, it is to be understood that, the present application may be implemented in any form which is not limited by the implementations as set forth herein. Rather, these implementations are provided for understanding the present application more thoroughly, and can fully convey the scope of the present application to those skilled in the art.

In the following paragraphs, the present application is described in more details with reference to the drawings by means of examples. Based on the following description, the advantages and features of the present application will be clearer. It is to be noted that the drawings are all in a very simplified form and use imprecise proportions, only for a convenient and clear description of the purpose of examples of the present application.

It is to be understood that the meaning of "on", "over" and "above" in the present application should be interpreted in the broadest manner such that "on" not only represents the meaning of "on" something without an intermediate feature or layer therebetween (i.e., directly on something) but also includes the meaning of "on" something with an intermediate feature or layer therebetween.

Further, spatial relative terms, such as "on", "over", "above", "up", "upper" and the like, may be used herein for ease of description to describe one element or feature's relationship to another element(s) or feature(s) as illustrated in the figures. The spatial relative terms are intended to encompass different orientations of a device in use or operation in addition to the orientation depicted in the drawings. The device may be otherwise oriented (rotated 90 degrees or at other orientations) and the spatial relative descriptors used herein may be interpreted likewise accordingly.

In the examples of the present application, the term "substrate" refers to a material onto which subsequent material layers are added. The substrate itself can be patterned. Materials added on top of the substrate can be patterned or can remain unpatterned. Furthermore, the substrate may comprise a wide variety of semiconductor materials, such as silicon, silicon germanium, germanium, gallium arsenide, indium phosphide, etc. Alternatively, the substrate can be made from an electrically non-conductive material, such as glass, plastic, or sapphire wafers.

In the examples of the present application, the term "layer" refers to a material portion including a region with a thickness. A layer may extend over the entirety of an underlying or overlying structure, or may have an extent less than the extent of the underlying or overlying structure. Furthermore, a layer may be a region of a homogeneous or inhomogeneous continuous structure that has a thickness less than the thickness of the continuous structure. For example, a layer can be located between a top surface and a bottom surface of the continuous structure, or between any pair of horizontal planes at a top surface and a bottom surface of the continuous structure. A layer may extend horizontally, vertically, and/or along an inclined surface. A layer may include multiple sub-layers. For example, an interconnection layer may comprise one or more conductors and contact sub-layers in which interconnection lines and/or via contacts are formed, and one or more dielectric sub-layers.

In the examples of the present application, the terms "first", "second" and the like are used to distinguish similar objects, but are not necessarily used to describe a specific sequence or sequential order.

The semiconductor structure to which the examples of the present application relate is at least a part of a structure to be used in subsequent processes to form a final device. Here, the final device may comprise a memory that includes, but is not limited to, a three-dimensional memory such as a 3D NAND, etc. Description is made below only by taking a 3D NAND three-dimensional memory as an example. It is to be noted that, the description below with respect to the 3D NAND three-dimensional memory is only used to illustrate the present application, instead of limiting the scope of the present application.

With the increase of the number of stack layers of the three-dimensional memory, etching depth of contact vias for forming the contacts is increased accordingly, which proposes higher requirements for the etching process of the contact vias. In order to reduce process difficulty and simplify process operations, self-aligned contact (SCT) structures are proposed at present, wherein each self-aligned contact structure is in electrical contact with a corresponding gate layer.

However, the manufacturing of SCT structures in the three-dimensional memory still has problems of significant process difficulty and numerous operation steps, and problems of damaging structures of devices and reducing structural stability of the devices.

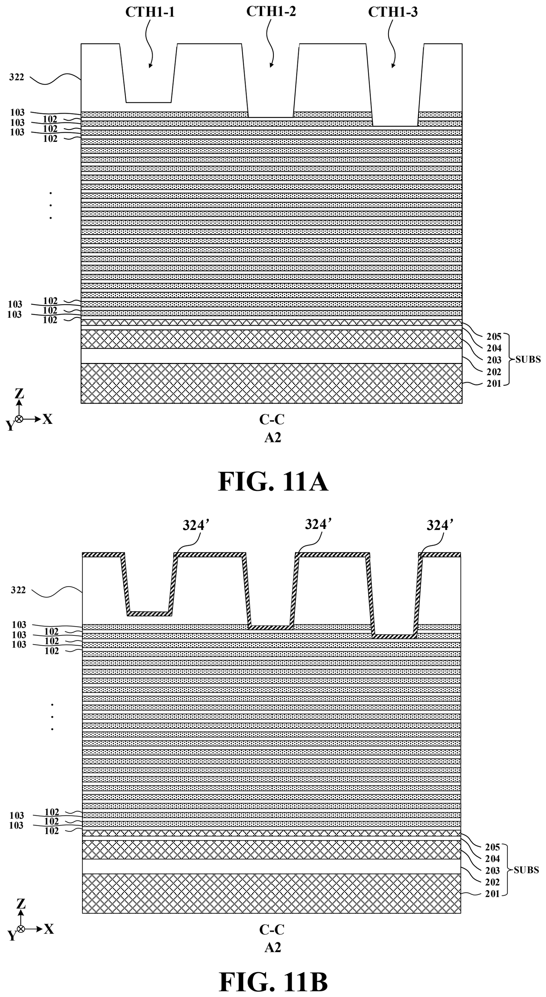

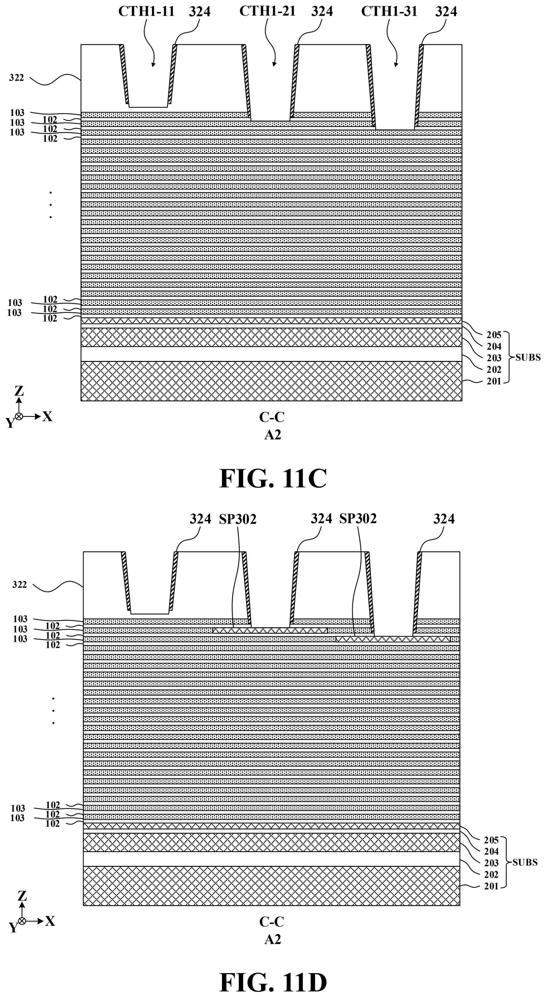

Referring to FIGs. 11A to 11F, forming a first contact structure and a plurality of second contact vias in a second region comprises:
forming a plurality of first contact vias (taking first contact vias CTH1-1, CTH1-2, CTH1-3 as an example) penetrating through a deck structure in the second region A2, referring to FIG. 11A, wherein the first contact via CTH1-1 extends to a third material layer 322 over a first dielectric layer, and the first contact vias CTH1-2, CTH1-3 extend to insulation layers 102 over corresponding second dielectric layers on a side of the first dielectric layer respectively;
forming a spacing material layer 324' at least covering sidewalls and bottom faces of the plurality of first contact vias, referring to FIG. 11B; and
sequentially removing the spacing material layer 324' and the third material layer 322 at the bottom of the first contact via CTH1-1, and sequentially removing the spacing material layer 324' and the insulation layers 102 at bottoms of the first contact vias CTH1-2, CTH1-3 to obtain the second contact vias (taking second contact vias CTH1-11, CTH1-21, CTH1-31 as an example), referring to FIGs. 11C to 11D.

A material of the insulation layer 102 includes, but is not limited to, silicon oxide, silicon nitride, silicon oxynitride, and other high dielectric constant (high k) dielectrics. The material of the insulation layer 102 may be the same as a material of the third material layer 322. Description is made below by taking both the material of the insulation layer 102 and the material of the third material layer 322 including silicon oxide as an example.

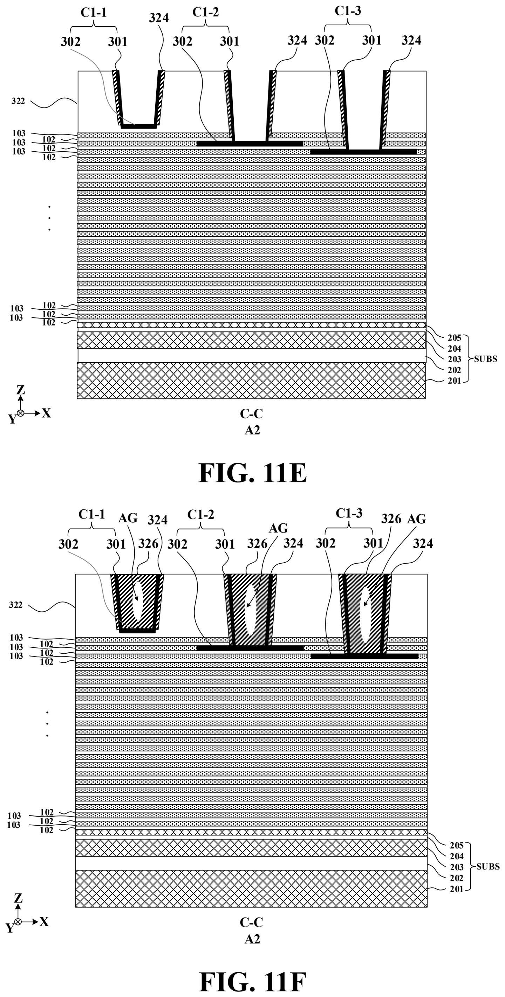

The first contact structure and second contact structure each comprises a lead-out portion and a connection portion. Forming the first contact structure and the second contact structures (taking the first contact structure C1-1 and the second contact structures C1-2, C1-3 as an example) comprises:
removing part of the second dielectric layers 103 on bottom faces of the second contact vias CTH1-21 and CTH1-31, referring to FIG. 11D; and
forming a conductive material on a bottom face and a sidewall of the second contact via CTH1-11, and forming a conductive material at positions where the second dielectric layers are removed, and on the sidewall of the second contact via, referring to FIG. 11E, wherein the conductive material on the bottom face of the second contact via CTH1-11 forms the connection portion 302 of the first contact structure, and the conductive material on the sidewall of the second contact via CTH1-11 forms the lead-out portion 301 of the first contact structure; the conductive material at the position where the second dielectric layer is removed forms the connection portion 302 of the second contact structure, and the conductive material on the sidewall of the second contact via forms the lead-out portion 301 of the second contact structure.

Referring to FIG. 11A, compared with a thickness of the insulation layer 102 below the first contact vias CTH1-2, CTH1-3, a thickness of the third material layer 322 below the first contact via CTH1-1 is thicker, and it is difficult to control the thickness of the remaining third material layer 322 during the formation of the first contact via CTH1-1.

Referring to FIGs. 11B to 11C, compared with the second contact vias CTH1-21, CTH1-31 that can stop on the dielectric layer 103 below the second contact vias CTH1-21, CTH1-31, since the third material layer 322 below the first contact via CTH1-1 is thicker, the third material layer 322 of a certain thickness is still present below the second contact via CTH1-11, such that the second contact via CTH1-11 cannot stop on the dielectric layer 103 below the second contact via CTH1-11.

Referring to FIG. 11D, compared with the case where part of the dielectric layer 103 below the second contact vias CTH1-21, CTH1-31 may be removed, and a space SP302 may be obtained at a position where part of the second dielectric layer on the bottom face of the second contact via is removed, the third material layer 322 of a certain thickness is still present below the second contact via CTH1-11, such that the second contact via CTH1-11 cannot stop on the dielectric layer 103 below the second contact via CTH1-11, part of the dielectric layer 103 below the second contact via CTH1-11 cannot be removed, and a space SP302 connected together with the second contact via CTH1-11 cannot be formed below the second contact via CTH1-11.

Referring to FIG. 11E, compared with the case where the lead-out portions 301 and the connection portions 302 of the obtained second contact structures C1-2, C1-3 may be connected to a corresponding second gate layer through the connection portions 302, the lead-out portion 301 and the connection portion 302 of the obtained first contact structure C1-1 cannot be connected to a corresponding first gate layer through the connection portion 302, resulting in failure or difficulty in leading-out the first gate layer by the first contact structure C1-1.

In order to solve at least one of the above problems existing in the related technology, examples of the present application provide a semiconductor structure and a manufacturing method thereof, and a memory system.

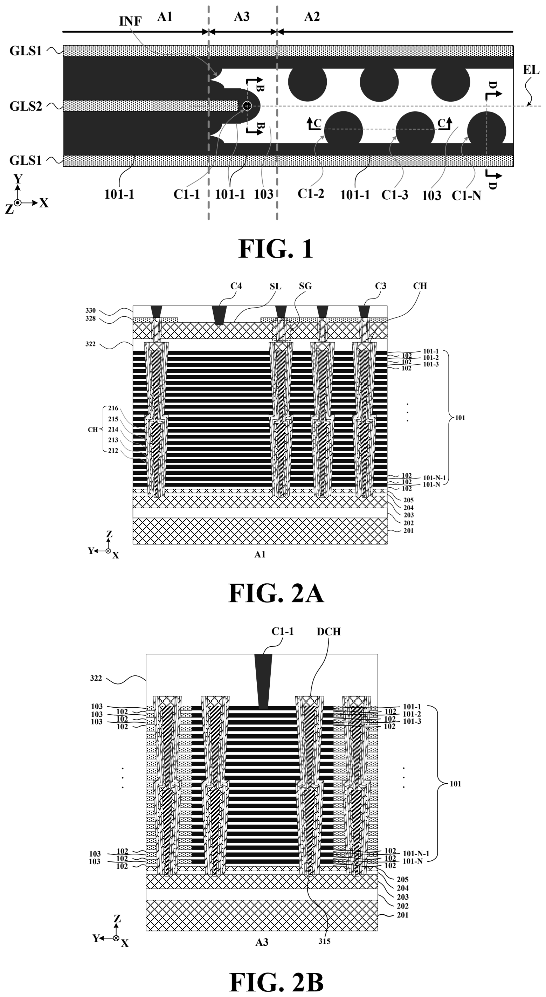

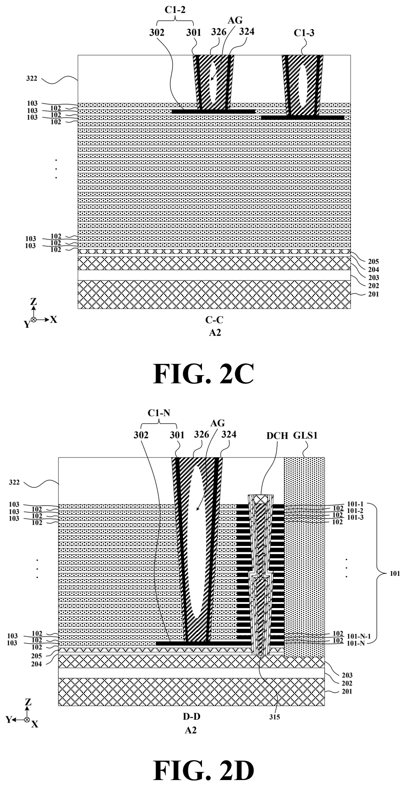

FIG. 1 is a schematic diagram of an X-Y plane of a first semiconductor structure provided in examples of the present application. FIG. 2A is a schematic diagram of a Y-Z cross-section of a first region of the semiconductor structure of FIG. 1; FIG. 2B is a schematic diagram of a B-B cross-section of a boundary region of the semiconductor structure of FIG. 1; FIG. 2C is a schematic diagram of a C-C cross-section of a second region of the semiconductor structure of FIG. 1; and FIG. 2D is a schematic diagram of a D-D cross-section of a second region of the semiconductor structure of FIG. 1.

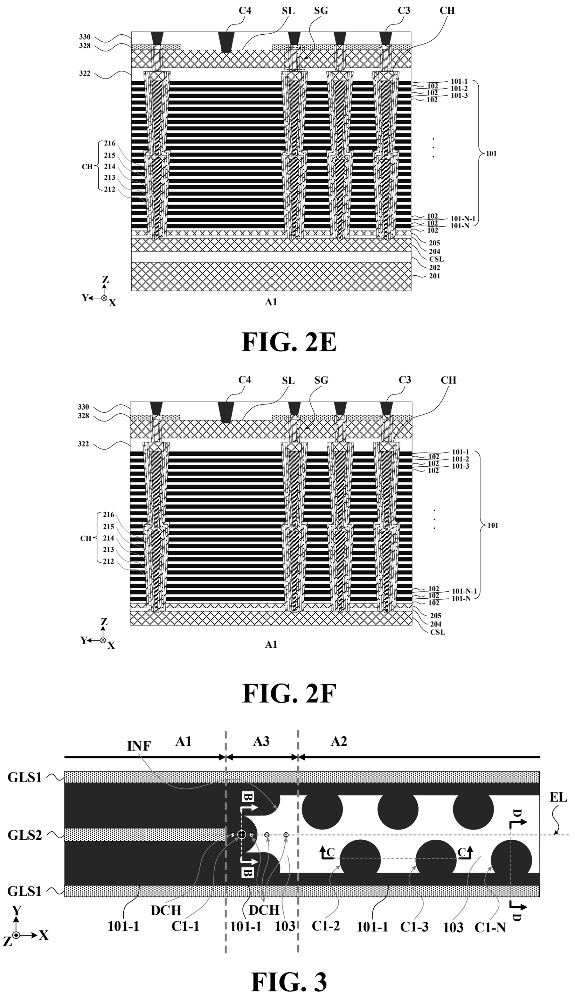

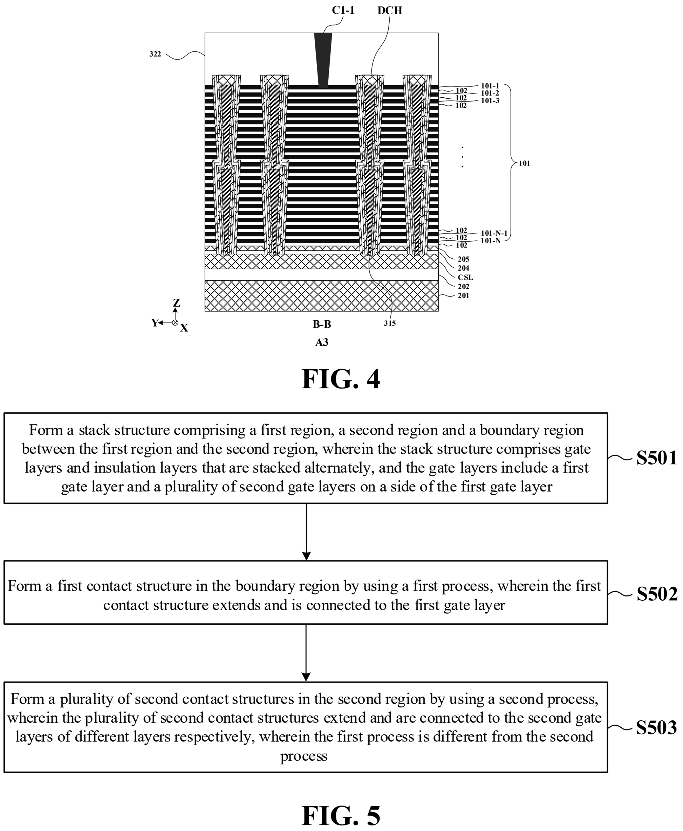

FIG. 3 is a schematic diagram of an X-Y plane of a fourth semiconductor structure provided in examples of the present application. FIG. 4 is a schematic diagram of a B-B cross-section of a boundary region of the semiconductor structure of FIG. 3. The schematic diagram of the Y-Z cross-section of the first region of the semiconductor structure of FIG. 3 may be understood with reference to FIG. 2A. The schematic diagram of the C-C cross-section of the second region of the semiconductor structure of FIG. 3 may be understood with reference to FIG. 2C. The schematic diagram of the D-D cross-section of the second region of the semiconductor structure of FIG. 3 may be understood with reference to FIG. 2D.

It is to be noted that, the schematic diagrams of the X-Y plane of a position corresponding to a first gate layer are shown in FIGs. 1 and 3. Meanwhile, in order to clearly show the relative position relationship of a first contact structure and a second contact structure with respect to the first gate layer and a second gate layer respectively, projections of the first contact structure and the second contact structure on the X-Y plane of the position corresponding to the first gate layer are also shown in perspective, wherein the first contact structure is connected to the first gate layer, and the second contact structure is connected to the corresponding second gate layer. The schematic diagram of the X-Y plane of a position corresponding to the second gate layer may be understood with reference to the schematic diagram of the X-Y plane of the position corresponding to the first gate layer.

Here and below, for ease of description, a first direction and a second direction in the examples of the present application are represented as two orthogonal directions parallel to a substrate (or substrate structure) plane, and a third direction is a stacking direction of a stack structure, i.e., a direction perpendicular to the substrate (or substrate structure) plane. The first direction may be represented as an X direction in the drawings, the second direction may be represented as a Y direction in the drawings, and the third direction may be represented as a Z direction in the drawings.

Referring to FIGs. 1 and 2A to 2D, and referring to FIGs. 3 and 4, according to a first aspect of the present application, a semiconductor structure is provided, comprising:
a stack structure comprising a first region A1, a second region A2, and a boundary region A3 between the first region A1 and the second region A2, wherein the stack structure comprises gate layers and insulation layers 102 that are stacked alternately; the gate layers include a first gate layer 101-1 and a plurality of second gate layers 101-2 to 101-N on a side of the first gate layer 101-1; a first contact structure C1-1 in the boundary region A3, extending and connected to the first gate layer 101-1; and
a plurality of second contact structures C1-2 to C1-N in the second region A2, extending and connected to the second gate layers 101-2 to 101-N of different layers respectively,
wherein a size of the first contact structure C1-1 in a direction perpendicular to a stacking direction of the stack structure is different from sizes of the second contact structures C1-2 to C1-N in the direction perpendicular to the stacking direction.

Here and in the description below, the term "gate layer" includes the first gate layer and the second gate layers; the term "contact structure" includes the first contact structure and the second contact structures; and the term "dielectric layer" includes a first dielectric layer and a second dielectric layer. Here and below, N is a natural number greater than or equal to 2.

In some examples, dielectric layers 103 are further disposed on planes where the corresponding gate layers of the stack structure of the second region A2 are located;
referring to FIGs. 1 and 2B, a periphery of a position where the first contact structure C1-1 is located corresponds to the gate layers and the insulation layers 102 that are stacked alternately; referring to FIGs. 1 and 2D, a part of peripheries of positions where the second contact structures C1-2 to C1-N are located corresponds to the gate layers and the insulation layers 102 that are stacked alternately, and referring to FIGs. 1 and 2C, the other part corresponds to the dielectric layers 103 and the insulation layers 102 that are stacked alternately.

In an example, the first contact structure C1-1 is in contact with the first gate layer corresponding to the periphery of the position where the first contact structure C1-1 is located, and the second contact structures C1-2 to C1-N are in contact with the second gate layers corresponding to a part of the peripheries of the positions where the second contact structures C1-2 to C1-N are located, respectively.

In some examples, the semiconductor structure further comprises:
a plurality of channel structures CH penetrating through the stack structure of the first region A1, with reference to FIGs. 1 and 2A; and
a plurality of third contact structures C3 in the first region A1, extending and connected to the different channel structures CH respectively,
wherein cross-sectional shapes of the first contact structure C1-1 and the third contact structures C3 in a plane perpendicular to the stacking direction are the same, with reference to FIGs. 1, 2A and 2B.

In an example, cross-sectional shapes of ones of the first contact structure C1-1 and the third contact structures C3 for achieving electrical connection in the plane perpendicular to the stacking direction are each a solid pillar shape or a hollow cylinder shape.

The first contact structure C1-1 and the third contact structures C3 are disposed together, thereby effectively controlling costs (for example, the first contact structure C1-1 and the third contact structures C3 may be obtained using the same mask layer, which can effectively control costs), the second gate layers 101-2 to 101-N are properly led out by the second contact structures C1-2 to C1-N, and the first gate layer 101-1 is properly led out by the first contact structure C1-1.

In some examples, the semiconductor structure further comprises:
a select gate layer SL located on the first gate layer 101-1, with reference to FIGs. 1 and 2A; and
a fourth contact structure C4 in the first region A1, extending and connected to the select gate layer SL,
wherein cross-sectional shapes of the first contact structure C1-1 and the fourth contact structure C4 in the plane perpendicular to the stacking direction are the same, with reference to FIGs. 1, 2A and 2B.

The first contact structure C1-1 and the fourth contact structure C4 are disposed together, thereby effectively controlling costs (for example, the first contact structure C1-1 and the fourth contact structure C4 may be obtained using the same mask layer, which can effectively control costs), the second gate layers 101-2 to 101-N are properly led out by the second contact structures C1-2 to C1-N, and the first gate layer 101-1 is properly led out by the first contact structure C1-1.

In some examples, referring to FIGs. 1, 2A and 2B, a top face of the first contact structure C1-1 is substantially flush with a top face of at least one of the third contact structure C3 or the fourth contact structure C4.

In an example, the first contact structure C1-1, the third contact structures C3 and the fourth contact structure C4 are disposed together, thereby effectively controlling costs (for example, the first contact structure C1-1, the third contact structures C3 and the fourth contact structure C4 may be obtained using the same mask layer, which can effectively control costs), the second gate layers 101-2 to 101-N are properly led out by the second contact structures C1-2 to C1-N, and the first gate layer 101-1 is properly led out by the first contact structure C1-1.

In some examples, referring to FIGs. 1, 2B, 2C and 2D, the size of the first contact structure C1-1 in a direction perpendicular to the stacking direction is less than the sizes of the second contact structures C1-2 to C1-N in the direction perpendicular to the stacking direction.

In some examples, referring to FIGs. 1, 2B, 2C and 2D, a range of the size of the first contact structure C1-1 in the direction perpendicular to the stacking direction is 100 nm to 500 nm, and a range of the sizes of the second contact structures C1-2 to C1-N in the direction perpendicular to the stacking direction is 500 nm to 3000 nm.

In some examples, referring to FIGs. 1, 2A, 2B, 2C and 2D, a material of the first contact structure C1-1 includes, but is not limited to, tungsten, cobalt, nickel, copper, aluminum, polysilicon, doped silicon, silicides, nitrides or any combination thereof. In an example, the material of the first contact structure C1-1 may be tungsten. A material of the second contact structures C1-2 to C1-N includes, but is not limited to, tungsten, cobalt, nickel, copper, aluminum, polysilicon, doped silicon, silicides, nitrides or any combination thereof. In an example, the material of the second contact structures C1-2 to C1-N may be tungsten.

In some examples, referring to FIGs. 1 and 3, the semiconductor structure further comprises: a plurality of first gate line slit GSL1 structures and a second gate line slit GSL2 structure between two adjacent ones of the first gate line slit GSL1 structures, wherein the first gate line slit GSL1 structures extend from the first region A1 to the second region A2, and the second gate line slit GSL2 structure extends from the first region A1 to the boundary region A3,
wherein the first contact structure C1-1 is located on an extension line of a straight line where the second gate line slit GSL2 structure is located, and is located at a position close to an end of the second gate line slit GSL2 structure.

Here and below, the gate line slit structure (including the first gate line slit GLS1 structure and the second gate line slit GLS2 structure) comprises a gate line isolation trench formed in the stack structure, and a filling material formed in the gate line isolation trench. The filling material may include polysilicon, silicon oxynitride or carbon.

Compared with the first gate line slit GSL1 structures, the second gate line slit GSL2 structure is shorter, and a landing region (which may be understood as a region where the first contact structure C1-1 is in contact with the first gate layer 101-1) of the first contact structure C1-1 is disposed at a position on the extension line EL of the second gate line slit GSL2 structure, such that the region at the position on the extension line EL of the second gate line slit GSL2 structure can be utilized effectively, thereby effectively controlling costs. For example, since no pattern is disposed in the stack structure at the position on the extension line EL of the second gate line slit GSL2 structure (for another example, no dummy channel structure DCH/channel structure CH is disposed in the stack structure), or since the position on the extension line EL of the second gate line slit GSL2 structure serves as the landing region of the first contact structure C1-1, the gate layers (including the first gate layer 101-1) and the insulation layers 102 stacked alternately may be formed around the position of the end of the second gate line slit GSL2 structure using the second gate line slit GSL2, without involving change of mask layer patterns of other relevant process layers. As such, without changing the mask layer patterns of other relevant process layers, the region at the position on the extension line EL of the second gate line slit GSL2 structure is utilized effectively, and the first gate layer 101-1 at the position of the end of the second gate line slit GSL2 structure can serve as the landing region of the first contact structure C1-1, so that the first gate layer 101-1 can be properly led out by the first contact structure C1-1 only by adaptively changing a mask pattern for forming the first contact structure C1-1 to the landing region. The second gate layers 101-2 to 101-N are properly led out by the second contact structures C1-2 to C1-N, and the first gate layer 101-1 is properly led out by the first contact structure C1-1.

In some examples, referring to FIGs. 1 and 3, the corresponding dielectric layer 103 of the stack structure in the second region A2 is located between two adjacent ones of the first gate line slit GSL1 structures, and the corresponding gate layers of the stack structure in the second region A2 are each located between the dielectric layer 103 and the corresponding first gate line slit GSL1 structure; the second contact structures C1-2 to C1-N are located between the extension line of the straight line where the second gate line slit GSL2 is located and two of the first gate line slit GSL1 structures; and part of the second contact structures C1-2 to C1-N between the extension line and one of the first gate line slit GSL1 structures and the other part of the second contact structures C1-2 to C1-N between the extension line and the other one of the first gate line slit GSL1 structures are in juxtaposition and in a staggered arrangement;
a side of the second contact structures C1-2 to C1-N close to the first gate line slit GSL1 structure is connected with the respective second gate layers 101-2 to 101-N.

The second contact structures C1-2 to C1-N are uniformly distributed on two sides close to the first gate line slit GSL1, which can increase the process window of forming the second contact structures C1-2 to C1-N, thus the costs are controlled effectively, and the second gate layers 101-2 to 101-N are properly led out by the second contact structures C1-2 to C1-N.

In some examples, referring to FIG. 3, the dielectric layer 103 is further disposed on a plane where the corresponding gate layer of the stack structure of the boundary region A3 is located; and the gate layer and the dielectric layer 103 between the first gate line slit GSL1 structure and the second gate line slit GSL2 structure in the boundary region A3 have an interface INF;
the interface INF is located between the first contact structure C1-1 and the second region A2; and the semiconductor structure further comprises at least one dummy channel structure DCH that is located on the extension line of the straight line along which the second gate line slit GSL2 extends and is located on at least one side of the first contact structure C1-1.

Compared with the first gate line slit GSL1 structure, the second gate line slit GSL2 structure is shorter (not extending to the second region A2). The landing region (which may be understood as the region where the first contact structure C1-1 is in contact with the first gate layer 101-1) of the first contact structure C1-1 may be disposed at the position on the extension line EL of the second gate line slit GSL2 structure, and the dummy channel structure DCH in the stack structure on at least one side of the first contact structure C1-1 supports the stack structure in the vicinity of the landing region, to prevent the stack structure in the vicinity of the landing region from tilting or bending.

In some examples, referring to FIG. 1, the dielectric layer 103 is further disposed on a plane where the corresponding gate layer of the stack structure of the boundary region A3 is located; and the gate layer and the dielectric layer 103 between the first gate line slit GSL1 structure and the second gate line slit GSL2 structure in the boundary region A3 have an interface INF;
the interface INF is located between the first contact structure C1-1 and the first region A1; and the gate layers and the insulation layers 102 that are stacked alternately are around the first contact structure C1-1 along the extension line of the straight line along which the second gate line slit GSL2 extends.

In some examples, referring to FIGs. 1, 2C and 2D,
the first contact structure C1-1 extends to the first gate layer 101-1 along the stacking direction of the stack structure;
each of the second contact structures C1-2 to C1-N comprises a lead-out portion 301 and a connection portion 302, wherein the lead-out portion 301 extends in a direction parallel to the stacking direction of the stack structure, and one end of the lead-out portion is connected with part of a top face of the connection portion 302; and the connection portion 302 extends in a direction perpendicular to the stacking direction and is connected to the corresponding second gate layers 101-2 to 101-N.

In some examples, referring to FIGs. 2C and 2D, the lead-out portion 301 and the connection portion 302 are formed integrally.

In some examples, the first contact structure C1-1 comprises a pillar-shaped conductive structure, and the lead-out portion 301 comprises a cylinder-shaped conductive structure.

FIG. 2E is a schematic diagram of a Y-Z cross-section of a first region of a second semiconductor structure provided in examples of the present application. The semiconductor structure of FIG. 2E may be understood as obtaining a common source layer CSL by performing subsequent processes on the basis of FIG. 2A: the common source layer CSL is achieved in a relevant process through the gate line slit (at least one of the first gate line slit GLS1 or the second gate line slit GLS2).

FIG. 2F is a schematic diagram of a Y-Z cross-section of a first region of a third semiconductor structure provided in examples of the present application. The semiconductor structure of FIG. 2F may be understood as obtaining a common source layer CSL by performing subsequent processes on the basis of FIG. 2A: the common source layer CSL is achieved in a backside process of a substrate 201. Referring to FIG. 2E or 2F, in some examples, the semiconductor structure further comprises: a common source layer CSL. In some examples, the common source layer CSL may be in contact with a channel layer 215 of the channel structure CH. In some other examples, the common source layer CSL may be in contact with a channel layer 315 of the dummy channel structure DCH. In some examples, a material of the common source layer CSL includes, but is not limited to, tungsten, cobalt, nickel, copper, aluminum, polysilicon, doped silicon, silicides, nitrides or any combination thereof. In an example, the material of the common source layer CSL may be polysilicon.

In some examples, the first contact structure C1-1 and the second contact structures C1-2 to C1-N are located on a first side of the channel structure CH, and the common source layer CSL is located on a second side of the channel structure CH, wherein the first side and the second side are two opposite sides of the channel structure CH in an extending direction.

Referring to FIG. 2E or 2F, in some examples, the first gate line slit GSL1 structure comprises a common source isolation portion (not shown in FIG. 2D) and a common source lead-out portion (not shown in FIG. 2D) sequentially located on a sidewall of the first gate line slit GSL1, and/or the second gate line slit GSL2 structure comprises a common source isolation portion (not shown in FIG. 2D) and a common source lead-out portion (not shown in FIG. 2D) sequentially located on a sidewall of the second gate line slit GSL2, wherein the common source lead-out portion extends into the common source layer CSL, the common source lead-out portion is in contact with the common source layer CSL, and the common source isolation portion is located between the gate layer and the common source lead-out portion. In some examples, a material of the common source lead-out portion includes, but is not limited to, tungsten, cobalt, nickel, copper, aluminum, polysilicon, doped silicon, silicides, nitrides or any combination thereof. In an example, the material of the common source lead-out portion may be polysilicon. In some examples, a material of the common source isolation portion includes, but is not limited to, silicon oxide, silicon nitride, silicon oxynitride and other high dielectric constant (high k) dielectrics. In an example, the material of the common source isolation portion may be silicon oxide.

In various examples of the present application, the first contact structure C1-1 and the second contact structures C1-2 to C1-N are disposed separately; the first contact structure C1-1 and the second contact structures C1-2 to C1-N are disposed in different regions respectively (the first contact structure C1-1 is disposed in the third region A3, and the second contact structures C1-2 to C1-N are disposed in the second region A2), and the sizes of the first contact structure C1-1 and the second contact structures C1-2 to C1-N in a direction perpendicular to the stacking direction are respectively set as different, such that the second gate layers 101-2 to 101-N are properly led out by the second contact structures C1-2 to C1-N, and the first gate layer 101-1 is properly led out by the first contact structure C1-1.

The semiconductor structure provided by the examples of the present application is similar to a semiconductor structure manufactured by a manufacturing method of a semiconductor structure in the following examples. The technical features not disclosed in detail in the examples of the present application may be understood with reference to the semiconductor structure manufactured by the following manufacturing method of the semiconductor structure, which are are no longer repeated here.

FIG. 5 is a flow diagram of a manufacturing method of a semiconductor structure provided by examples of the present application. Referring to FIG. 5, according to a second aspect of the present application, a manufacturing method of a semiconductor structure is provided, comprising:
S501, forming a stack structure comprising a first region, a second region and a boundary region between the first region and the second region, wherein the stack structure comprises gate layers and insulation layers that are stacked alternately, and the gate layers include a first gate layer and a plurality of second gate layers on a side of the first gate layer;
S502, forming a first contact structure in the boundary region by using a first process, wherein the first contact structure extends and is connected to the first gate layer; and
S503, forming a plurality of second contact structures in the second region by using a second process, wherein the plurality of second contact structures extend and are connected to the second gate layers of different layers respectively,
wherein the first process is different from the second process.

It should be understood that the operations as illustrated in FIG. 5 are not exclusive, and other operations may be also performed before, after, or between any of the illustrated operations. The sequence of the operations illustrated in FIG. 5 can be adjusted according to actual needs.

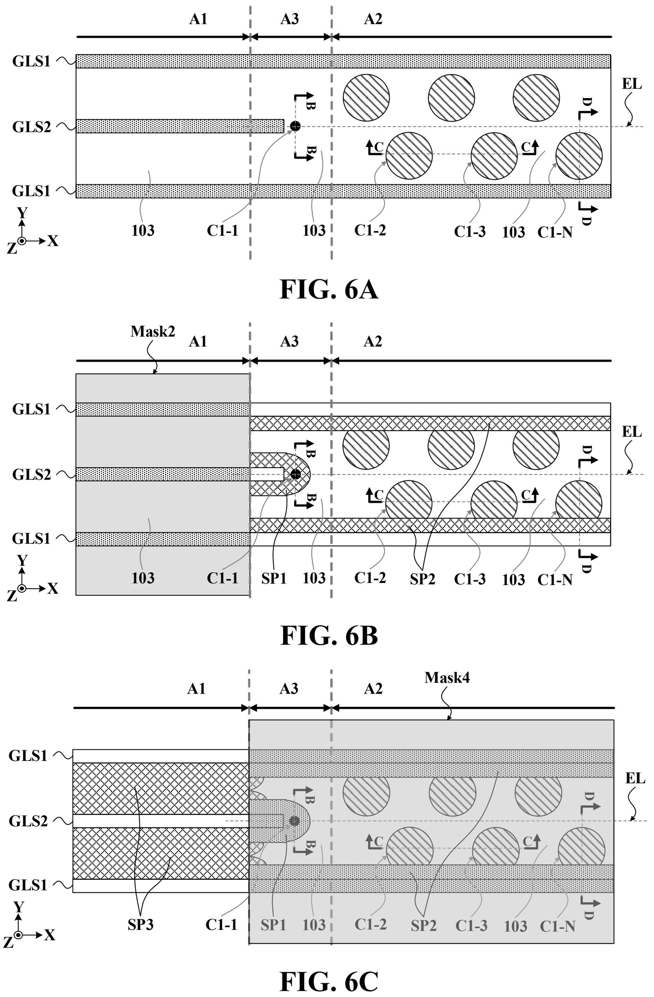

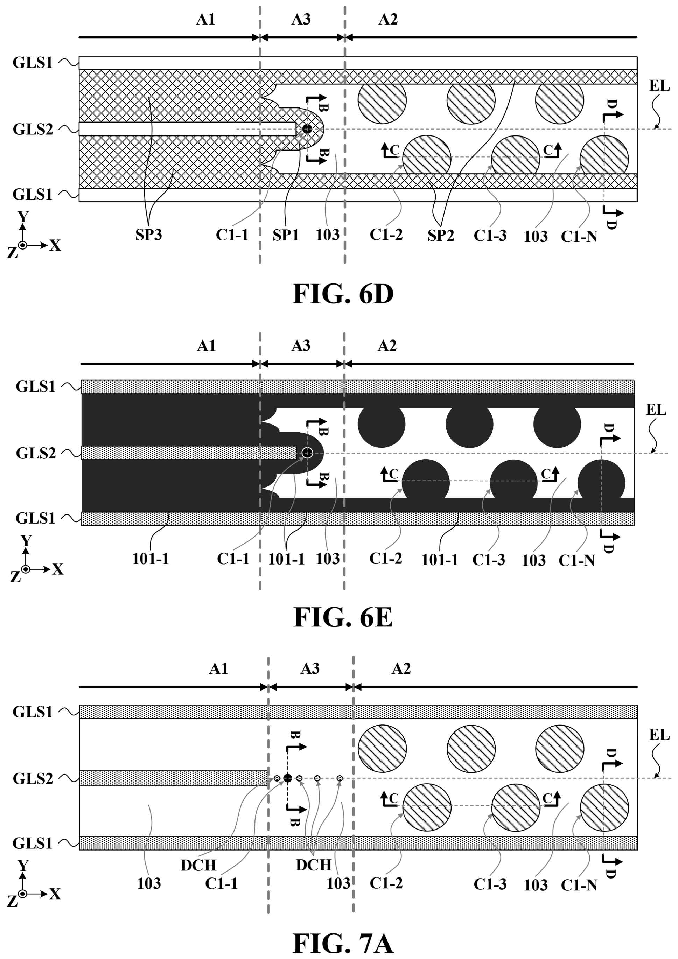

FIGs. 6A to 6E are schematic diagrams of an X-Y plane of a manufacturing process of a stack structure of a first semiconductor structure provided by examples of the present application. FIGs. 7A to 7E are schematic diagrams of an X-Y plane of a manufacturing process of a stack structure of a second semiconductor structure provided by examples of the present application. The operations as illustrated in FIGs. 6A to 6E and 7A to 7E are not exclusive, and other operations may be also performed before, after, or between any of the illustrated operations. The sequence can be adjusted according to actual needs.

It is to be noted that FIGs. 6A to 6D and 7A to 7D show the schematic diagrams of the X-Y plane of a position corresponding to the first gate layer. Meanwhile, in order to clearly show the relative position relationship of the first contact structure and the second contact structure with respect to the first gate layer and the second gate layer respectively, projections of a position corresponding to the first contact structure and a position corresponding to the second contact structure on the X-Y plane of the position corresponding to the first gate layer are also shown in perspective. The schematic diagram of the X-Y plane of a position corresponding to the second gate layer may be understood with reference to the schematic diagram of the X-Y plane of the position corresponding to the first gate layer.

In some examples, the formation of the gate layers (including the first gate layer and the second gate layers) are performed simultaneously. Here and below, FIGs. 6A to 6E and 7A to 7E are illustrated by taking the X-Y plane of the position corresponding to the first gate layer as an example.

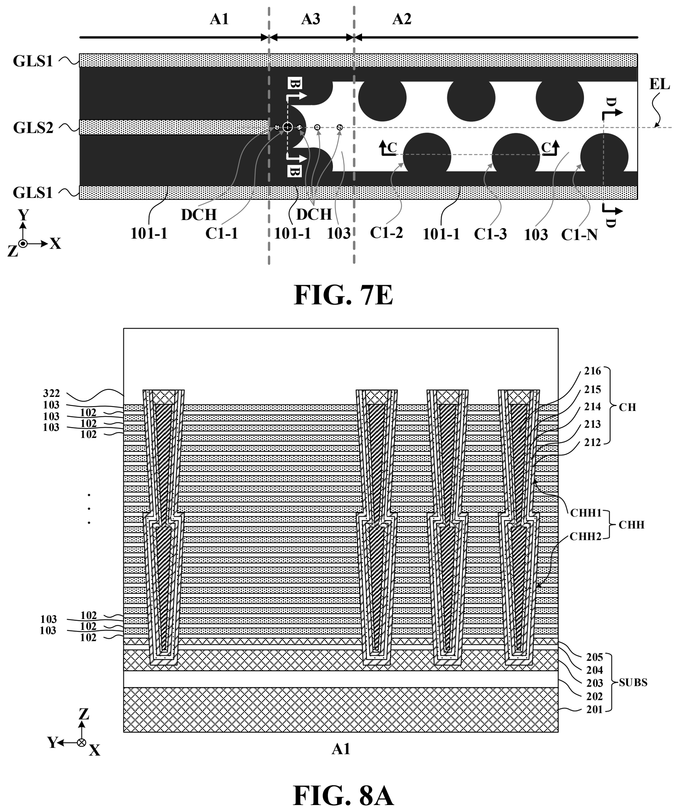

FIG. 8A is a schematic diagram of a Y-Z cross-section of the first region of the semiconductor structure of FIG. 6A or 7A; FIG. 8B is a schematic diagram of a B-B cross-section of the boundary region of the semiconductor structure of FIG. 6A or 7A; FIG. 8C is a schematic diagram of a C-C cross-section of the second region of the semiconductor structure of FIG. 6A or 7A; and FIG. 8D is a schematic diagram of a D-D cross-section of the second region of the semiconductor structure of FIG. 6A or 7A.

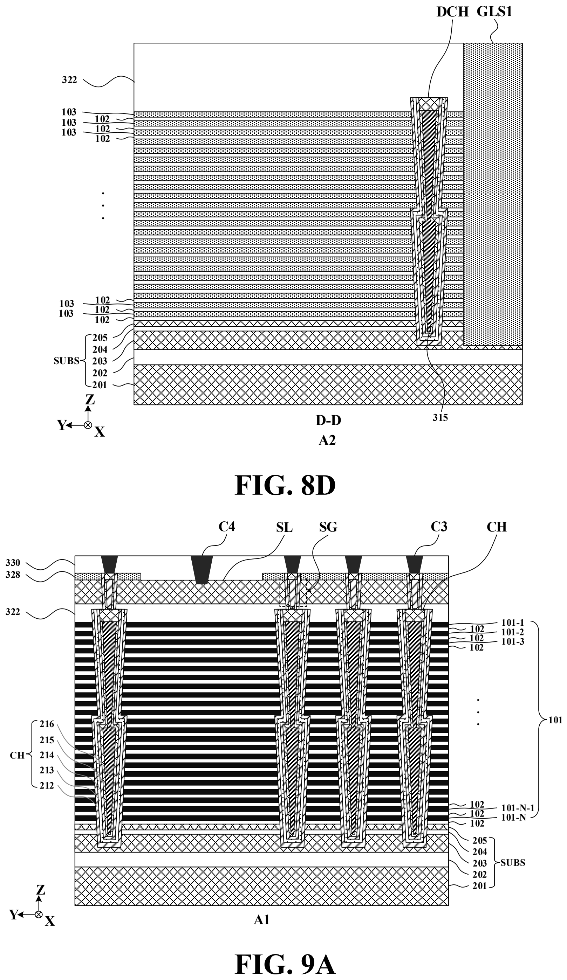

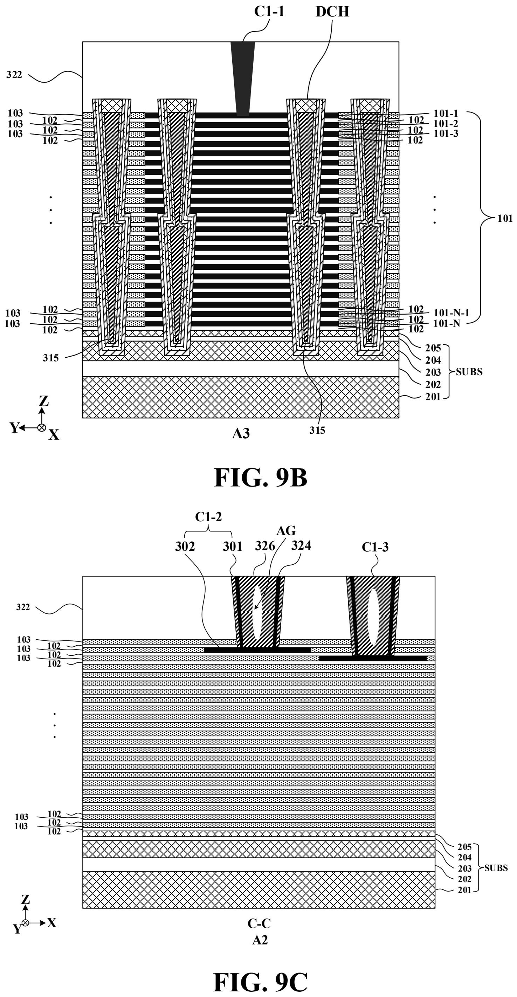

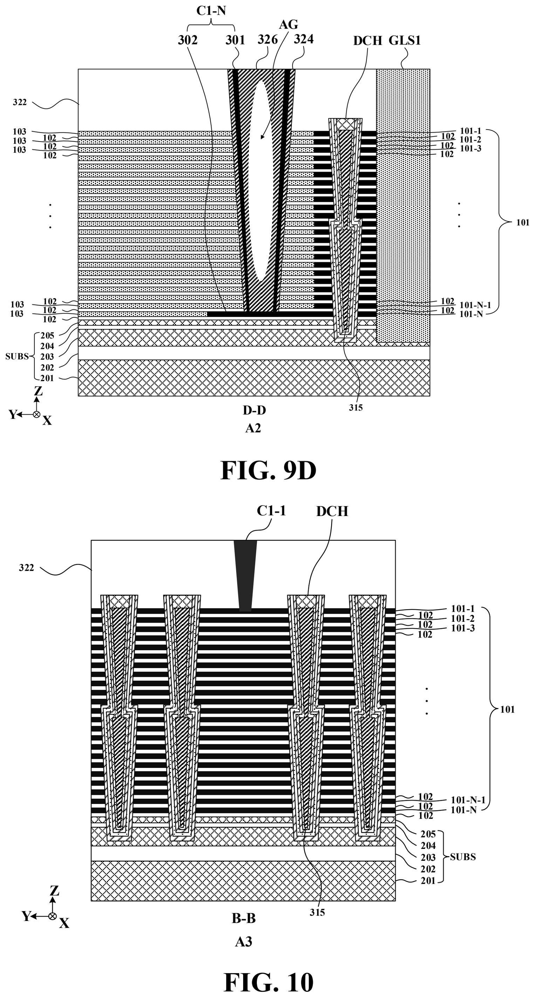

FIG. 9A is a schematic diagram of a Y-Z cross-section of the first region of the semiconductor structure of FIG. 6E; FIG. 9B is a schematic diagram of a B-B cross-section of the boundary region of the semiconductor structure of FIG. 6E; FIG. 9C is a schematic diagram of a C-C cross-section of the second region of the semiconductor structure of FIG. 6E; and FIG. 9D is a schematic diagram of a D-D cross-section of the second region of the semiconductor structure of FIG. 6E.

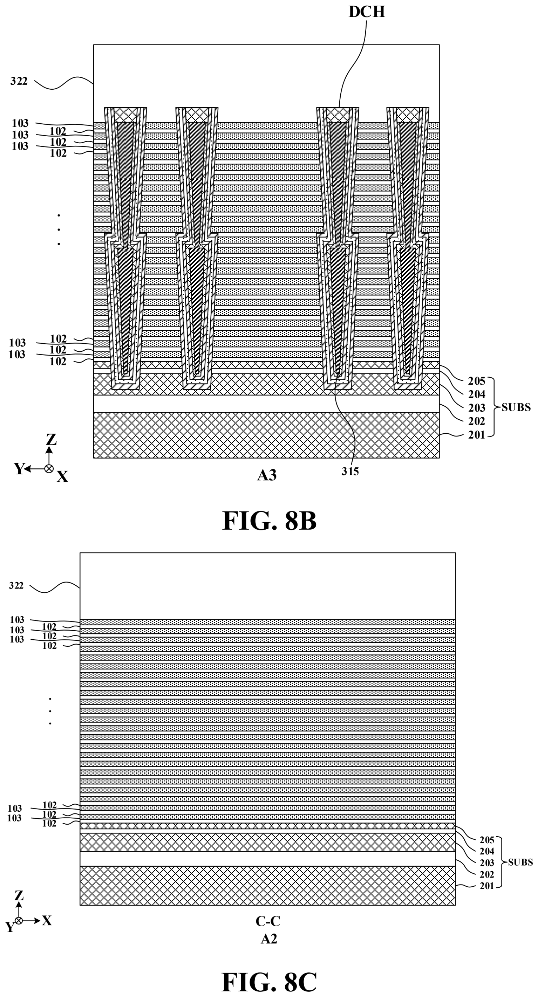

The schematic diagram of the Y-Z cross-section of the first region of the semiconductor structure, the schematic diagram of the B-B cross-section of the boundary region of the semiconductor structure, the schematic diagram of the C-C cross-section of the second region of the semiconductor structure and the schematic diagram of the D-D cross-section of the second region of the semiconductor structure of FIGs. 6B to 6D may be understood with reference to FIGs. 8A, 8B, 8C and 8D and/or 9A, 9B, 9C and 9D respectively and in conjunction with corresponding process operations, which is no longer repeated here and below.

FIG. 10 is a schematic diagram of a B-B cross-section of the boundary region of the semiconductor structure of FIG. 7E. The schematic diagram of the Y-Z cross-section of the first region of the semiconductor structure of FIG. 7E may be understood with reference to FIG. 9A. The schematic diagram of the C-C cross-section of the second region of the semiconductor structure of FIG. 7E may be understood with reference to FIG. 9C. The schematic diagram of the D-D cross-section of the second region of the semiconductor structure of FIG. 7E may be understood with reference to FIG. 9D.

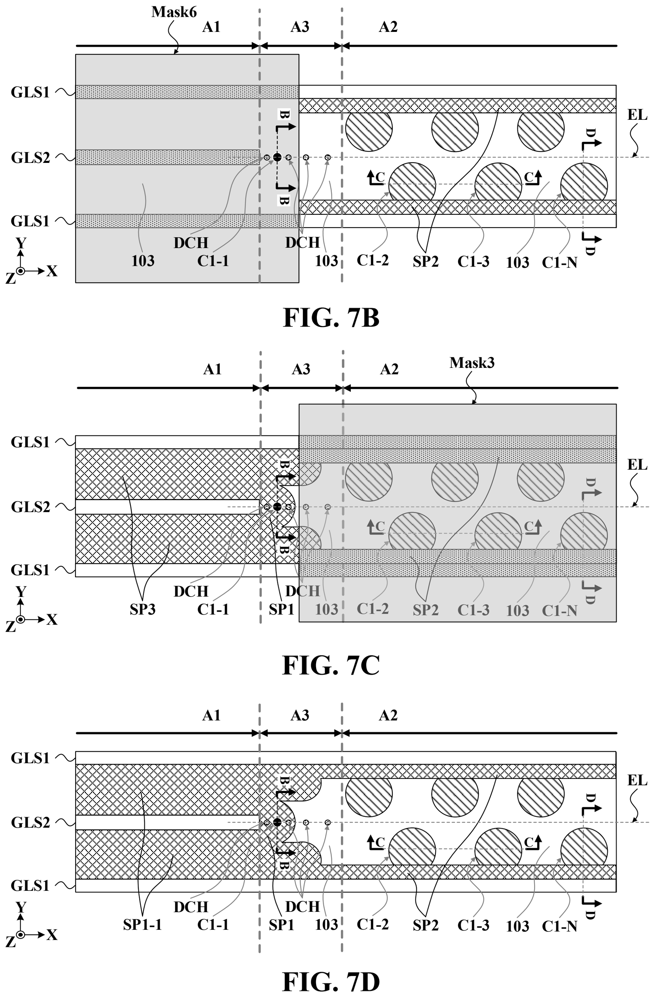

The schematic diagram of the Y-Z cross-section of the first region of the semiconductor structure, the schematic diagram of the C-C cross-section of the second region of the semiconductor structure and the schematic diagram of the D-D cross-section of the second region of the semiconductor structure of FIGs. 7B to 7D may be understood with reference to FIGs. 8A, 8C and 8D and/or 9A, 9C and 9D respectively and corresponding process operations, and the schematic diagrams of the B-B cross-section of the second region of the semiconductor structure of FIGs. 7B to 7D may be understood with reference to FIG. 8B and/or FIG. 10 and in conjunction with corresponding process operations, which are no longer repeated here and below.

Operation S501 is performed to form the stack structure.

Referring to FIGs. 6A to 6E and 7A to 7E, in some examples, forming the stack structure comprises:
forming a deck structure comprising a first region, a second region and a boundary region between the first region and the second region, wherein the deck structure comprises dielectric layers and insulation layers that are stacked alternately; and
replacing the dielectric layers of the first region, at least part of the dielectric layers of the boundary region and at least part of the dielectric layers of the second region with gate layers, to obtain the stack structure.

Referring to FIGs. 6A, 8A, 8B, 8C and 8D, the deck structure is formed.

The deck structure comprises several insulation layers 102 and dielectric layers 103 that are stacked alternately. The deck structure comprises the first region A1, the second region A2 and the boundary region A3 between the first region A1 and the second region A2.

Referring to FIGs. 1 and 2A, in some examples, the first region A1 may be used to form a channel structure CH; the second region A2 may be used to form a second contact structure for leading out a second gate layer of the channel structure CH; and the boundary region A3 may be used to form a first contact structure for leading out a first gate layer of the channel structure CH.

Referring to FIG. 1, in some examples, an interface between the first region A1 and the boundary region A3 may be an interface formed by passing through an end of the interface INF in an extending direction towards the first region A1 and extending along a Y direction, and an interface between the second region A2 and the boundary region A3 may be an interface formed by extending along the Y direction in a region between the second contact structure of the second region A2 closest to the first region A1 and a landing region of the first contact structure.

Referring to FIG. 3, in some examples, the interface between the first region A1 and the boundary region A3 may be an interface formed by passing through an end of the second gate line slit GLS2 in an extending direction towards the second region A2 and extending along the Y direction, and the interface between the second region A2 and the boundary region A3 may be an interface formed by extending along the Y direction in a region between the second contact structure of the second region A2 closest to the first region A1 and the interface INF.

In some examples, a material of the insulation layer 102 includes, but is not limited to, silicon oxide, silicon nitride, silicon oxynitride, and other high dielectric constant (high k) dielectrics, and a material of the dielectric layer 103 includes, but is not limited to, nitride, silicon carbide, silicon and silicon germanium. In some examples, the dielectric layer 103 may be formed from silicon nitride (Si₃N₄), and the insulation layer 102 may be formed from silicon oxide (SiO₂), such that the formed stack structure is a nitride-oxide (NO) stack. In some examples, the insulation layer 102 and the dielectric layer 103 may have the same thickness as each other, or may have a different thickness from each other. In subsequent processes, at least part of the dielectric layers 103 may be removed, and a gate metal material is filled at positions where they are removed to form the first gate layer and the second gate layer (referring to FIGs. 9A to 9D). The first gate layer and the second gate layer may comprise a metal tungsten (W).

In some examples, the insulation layers 102 and the dielectric layers 103 may be formed by a process such as a physical vapor deposition (PVD) process, a chemical vapor deposition (CVD) process, an atomic layer deposition (ALD) process, etc.

In some examples, a substrate structure SUBS on which the deck structure may be formed is provided, and may have a main surface (the X-Y plane in the drawings) extending in a first direction and a second direction as the horizontal direction.

In some examples, selection can be made according to actual demands of the device. The substrate structure SUBS may be a composite deck structure comprising a liner oxide layer 202, a bottom polysilicon layer 203, a buffer oxide layer 204 and a top polysilicon layer 205 formed by stacking on a substrate 201 sequentially along a third direction (the Z direction in the drawings). A material of the substrate 201 may include a silicon (Si) substrate, a germanium (Ge) substrate, a silicon germanium (SiGe) substrate, a silicon-on-insulator (SOI) substrate or a germanium-on-insulator (GOI) substrate, etc. A material of the liner oxide layer 202 may include silicon oxide; a material of the bottom polysilicon layer 203 may include polysilicon; a material of the buffer oxide layer 204 may include silicon oxide; and a material of the top polysilicon layer 205 may include polysilicon. In some examples, the liner oxide layer 202, the bottom polysilicon layer 203, the buffer oxide layer 204 and the top polysilicon layer 205 on the substrate 201 may all be formed by a process such as a PVD process, a CVD process or an ALD process, or the like.

The substrate structure SUBS formed in such way is suitable for selective epitaxial growth (SEG) of silicon on a back side of the substrate 201 in following processes to form a silicon epitaxial layer, and to achieve leading-out of a common source layer CSL (referring to FIGs. 2A to 2D above) on the back side of the substrate 201.

In some examples, the bottom polysilicon layer 203 may be removed through the gate line slit (at least one of the first gate line slit GLS1 or the second gate line slit GLS2), and part of a blocking dielectric layer 212, a charge trapping layer 213 and a tunneling dielectric layer 214 (an ONO film) of part of the channel structure CH are removed to expose part of a channel layer 215 of the channel structure CH; and then epitaxial growth of silicon is performed based on the remained bottom polysilicon layer 203 to form the silicon epitaxial layer to achieve the common source layer CSL in contact with the channel layer 215 of the channel structure CH. As such, the obtained common source layer CSL may be referred to the semiconductor structure of FIG. 2E.

In some other examples, the substrate 201, the liner oxide layer 202, part of the bottom polysilicon layer 203 may be removed from the back side of the substrate 201 sequentially, and part of the blocking dielectric layer 212, the charge trapping layer 213 and the tunneling dielectric layer 214 (an ONO film) of part of the channel structure CH are removed to expose part of the channel layer 215 of the channel structure CH; and then epitaxial growth of silicon is performed based on the remained bottom polysilicon layer 203 to form the silicon epitaxial layer, to achieve the common source layer CSL in contact with the channel layer 215 of the channel structure CH. As such, the obtained common source layer may be referred to the semiconductor structure of FIG. 2F.

In some examples, the channel structure CH comprises the blocking dielectric layer 212, the charge trapping layer 213, the tunneling dielectric layer 214, the channel layer 215 and a filling layer 216 that are stacked sequentially along a radial direction of a channel hole. In some examples, the blocking dielectric layer 212, the charge trapping layer 213, the tunneling dielectric layer 214 and the channel layer 215 are sequentially formed in this order along a sidewall and a bottom surface of the memory channel hole. The blocking dielectric layer 212 is used to block outflow of charges in a memory layer, and its material may include silicon oxide. The charge trapping layer 213 is used to trap and store charges, and its material may include silicon nitride. Electrons from the channel layer 215 may tunnel through the tunneling dielectric layer 214 into the charge trapping layer 213, a material of the tunneling dielectric layer 214 may include silicon oxide, and a material of the channel layer 215 may include polysilicon. The filling layer 216 may include silicon oxide or polysilicon, which means that the filling layer here is replaced by the same material as the channel layer 215. In some examples, the blocking dielectric layer 212, the charge trapping layer 213, the tunneling dielectric layer 214 and the channel layer 215 are called an ONOP film.

Referring to FIG. 8A, the deck structure provided by the examples of the present application comprise a first sub-deck structure and a second sub-deck structure on the first sub-deck structure. The channel hole CHH in the deck structure is formed in two times: a first sub-channel hole CHH1 is etched in the first sub-deck structure and a second sub-channel hole CHH2 is etched in the second sub-deck structure formed on the first sub-deck structure, respectively, and the first sub-channel hole CHH1 and the second sub-channel hole CHH2 are connected together to form the channel hole CHH. The channel hole CHH in the memory as shown in FIG. 8A should not be understood as limitation on the formation process of the channel hole CHH. In some examples, the process of forming the channel hole CHH is not limited thereto. The channel hole CHH may be formed in two times, or in more times, which can be selected according to actual demands. For example, when there are a larger number of the dielectric layers and the insulation layers alternately stacked in the deck structure, the deck structure needs more sub-deck structures (e.g., the above-mentioned first sub-deck structure, the second sub-deck structure, etc.), and accordingly, the channel hole CHH in the deck structure may be formed in more times.

In some examples, the channel hole CHH is formed by a lithography-etch (LE) process.

Here and below, the etching (or removal) process used may include a wet etching process, a dry etching process, etc., for example, a plasma etching process. A deposition (or filling) process used may include a PVD process, a CVD process, or an ALD process, or other processes. For example, a Plasma Enhanced Chemical Vapor Deposition (PECVD) process is used.

FIGs. 6A to 6E and 7A to 7E illustrate two kinds of methods for obtaining the stack structure by means of example. The method for forming the stack structure is not limited thereto.

Referring to FIGs. 6A, 6B, 6C, 6D and 6E, the stack structure is formed.

Referring to FIG. 6A, in some examples, the gate line slits are formed in the deck structure, and include a plurality of first gate line slits GLS1 and a second gate line slit GLS2 between two adjacent ones of the first gate line slits, wherein the first gate line slits GLS1 extend from the first region A1 to the second region A2, and the second gate line slit GLS2 extends from the first region A1 into the boundary region A3.

Here and below, the gate line slit (including the first gate line slit GLS1 and the second gate line slit GLS2) comprises a gate line isolation trench formed in the deck structure, and a filling material formed in the gate line isolation trench. The filling material may include polysilicon, silicon oxynitride or carbon.

Referring to FIG. 6B, in some examples, removing part of the dielectric layer 103 of the boundary region A3 comprises:
forming a second mask layer Mask2 covering the first region A1; and removing part of the dielectric layer 103 of the boundary region A3 together with part of the dielectric layer 103 of the second region A2 by using the second gate line slit GLS2 of the boundary region A3, and the first gate line slits GLS1 of the boundary region A3 and the second region A2.

It is to be noted that, after forming the second mask layer Mask2 and before removing part of the dielectric layer 103, the filling material at the second gate line slit GLS2 of the boundary region A3 and at the first gate line slits GLS1 of the boundary region A3 and the second region A2 needs to be removed.

As such, a space SP1 is formed at a position where part of the dielectric layer 103 is removed through the second gate line slit GLS2 of the boundary region A3, and a space SP2 is formed at a position where part of the dielectric layer 103 is removed through the first gate line slits GLS1 of the boundary region A3 and the second region A2.

Referring to FIG. 6C, in some examples, removing the dielectric layer 103 of the first region A1 comprises:
forming a fourth mask layer Mask4 covering the boundary region A3 and the second region A2; and removing the dielectric layer 103 of the first region A1 by using the first gate line slit GLS1 and the second gate line slit GLS2 of the first region A1.

It is to be noted that, after forming the fourth mask layer Mask4 and before removing part of the dielectric layer 103, the filling material at the second gate line slit GLS2 and the first gate line slit GLS1 of the first region A1 needs to be removed.

As such, a space SP3 is formed at the position where the dielectric layer 103 of the first region A1 is removed.

It is to be noted that, before forming the fourth mask layer Mask4, a filling material needs to be formed at the space SP1, the space SP2, the second gate line slit GLS2 of the boundary region A3, and the first gate line slits GLS1 of the boundary region A3 and the second region A2. The filling material may include polysilicon, silicon oxynitride or carbon.

In some examples, the second mask layer Mask2 and the fourth mask layer Mask4 are complementary patterns. In some examples, the second mask layer Mask2 and the fourth mask layer Mask4 may be formed using one mask by exposing a positive photoresist and a negative photoresist, respectively.

Referring to FIG. 6D, in some examples, the fourth mask layer Mask4 is removed, and the filling material at the space SP1, the space SP2, the second gate line slit GLS2 of the boundary region A3, and the first gate line slits GLS1 of the boundary region A3 and the second region A2 is removed, to obtain the space SP1, the space SP2 and the space SP3 that are interconnected together.

Here, where the space SP1, the space SP2 and the space SP3 that are interconnected together are obtained may be positions corresponding to the first gate layer and the second gate layers.

Referring to FIG. 6E, in some examples, a conductive material is filled at the space SP1, the space SP2 and the space SP3 that are interconnected together, to obtain the first gate layer and the second gate layers.

It is to be noted that, here and below, the term "conductive material" includes, but is not limited to, tungsten, cobalt, nickel, copper, aluminum, polysilicon, doped silicon, silicides, nitrides or any combination thereof. In an example, the conductive material includes, but is not limited to, tungsten. In an example, the conductive material includes, but is not limited to, titanium nitride. In an example, the conductive material includes, but is not limited to, polysilicon.

A material of the first gate layer and the second gate layers includes tungsten.

Furthermore, a filling material is formed at the second gate line slit GLS2 and the first gate line slits GLS1. The filling material may include polysilicon, silicon oxynitride or carbon.

As such, the dielectric layers of the first region A1, at least part of the dielectric layers of the boundary region A3 and at least part of the dielectric layers 103 of the second region A2 are replaced with the gate layers to obtain the stack structure.

Referring to FIGs. 7A, 7B, 7C, 7D and 7E, the stack structure is formed.

Referring to FIG. 7A, in some examples, the gate line slits are formed in the deck structure, and include a plurality of first gate line slits GLS1 and a second gate line slit GLS2 between two adjacent ones of the first gate line slits, wherein the first gate line slits GLS1 extend from the first region A1 to the second region A2, and the second gate line slit GLS2 extends from the first region A1 into a boundary between the boundary region A3 and the first region A1.

Here, the gate line slit (including the first gate line slit GLS1 and the second gate line slit GLS2) comprises a gate line isolation trench formed in the deck structure, and a filling material formed in the gate line isolation trench. The filling material may include polysilicon, silicon oxynitride or carbon.

Referring to FIG. 7B, in some examples, removing part of the dielectric layer 103 of the boundary region A3 comprises:
forming a sixth mask layer Mask6 covering the first region A1; and removing part of the dielectric layer 103 of the boundary region A3 together with part of the dielectric layer 103 of the second region A2 by using the first gate line slits GLS1 of the second region A2 and the boundary region A3.

In some examples, the sixth mask layer Mask6 may cover the first region A1, or cover the first region A1 and part of the boundary region A3. Here and below, the illustration is made by taking the sixth mask layer Mask6 covering the first region A1 and part of the boundary region A3 as an example.

It is to be noted that, after forming the sixth mask layer Mask6 and before removing part of the dielectric layer 103, the filling material at the first gate line slits GLS1 of part of the boundary region A3 and the second region A2 needs to be removed.

As such, the space SP2 is formed at the position where part of the dielectric layer 103 is removed through the first gate line slits GLS1 of part of the boundary region A3 and the second region A2.

Referring to FIG. 7C, in some examples, removing part of the dielectric layer 103 of the boundary region A3 comprises:
forming a third mask layer Mask3 covering the second region A2; and removing part of the dielectric layer 103 of the boundary region A3 together with the dielectric layer 103 of the first region A1, by using the first gate line slits GLS1 of the first region A1 and the boundary region A3 and the second gate line slit GLS2 of the first region A1 and the boundary region A3.

In some examples, the third mask layer Mask3 may cover the second region A2, or cover the second region A2 and part of the boundary region A3. Here and below, the illustration is made by taking the third mask layer Mask3 covering the second region A2 and part of the boundary region A3 as an example.

It is to be noted that, after forming the third mask layer Mask3 and before removing part of the dielectric layer 103, the filling material at the second gate line slit GLS2 of the first region A1 and the first gate line slits GLS1 of part of the boundary region A3 and the first region A1 needs to be removed.

As such, the space SP3 is formed at the position where the dielectric layer 103 of the first region A1 is removed, and the space SP1 is formed at the position where the dielectric layer 103 of part of the boundary region A3 is removed, thereby obtaining the space SP1 and the space SP3 that are interconnected together.

It is to be noted that before forming the third mask layer Mask3, a filling material needs to be formed at the space SP2 and the first gate line slits GLS1 of the boundary region A3 and the second region A2, wherein the filling material may include polysilicon, silicon oxynitride or carbon.

In some examples, the sixth mask layer Mask6 and the third mask layer Mask3 are complementary patterns. In some examples, the sixth mask layer Mask6 and the third mask layer Mask3 may be formed using one mask by exposing a positive photoresist and a negative photoresist, respectively.

Referring to FIG. 7D, in some examples, the third mask layer Mask3 is removed, and the filling material at the space SP2, and the first gate line slits GLS1 of part of the boundary region A3 and the second region A2 is removed, to obtain the space SP1, the space SP2 and the space SP3 that are interconnected together.

Here, where the space SP1, the space SP2 and the space SP3 that are interconnected together are obtained may be positions corresponding to the first gate layer and the second gate layers.

Referring to FIG. 7E, in some examples, a conductive material is filled at the space SP1, the space SP2 and the space SP3 that are interconnected together to obtain the first gate layer and the second gate layers.

A material of the first gate layer and the second gate layers includes tungsten.

Furthermore, a filling material is formed at the second gate line slit GLS2 and the first gate line slits GLS1, wherein the filling material may include polysilicon, silicon oxynitride or carbon.

As such, the dielectric layers of the first region A1, at least part of the dielectric layers of the boundary region A3 and at least part of the dielectric layers 103 of the second region A2 are replaced with the gate layers to obtain the stack structure.

Referring to FIGs. 7A, 7B, 7C, 7D and 7E, in some examples, part of the dielectric layer 103 of the boundary region A3 and the dielectric layer 103 of the first region A1 are removed together; and the method further comprises:
before removing part of the dielectric layer 103 of the boundary region A3, forming at least one dummy channel structure DCH around a position where the first contact structure is located, wherein the dummy channel structure DCH is located on an extension line EL of a straight line along which the second gate line slit GLS2 extends, and is located on at least one side of the position where the first contact structure is located.

In some examples, the dummy channel structure DCH is not used to or is disabled to achieve storage function.

In some examples, the dummy channel structure DCH is located on the extension line EL of the straight line along which the second gate line slit GLS2 extends, and is located on two sides of the position where the first contact structure is located.

In an example, the dummy channel structure DCH is located on the extension line EL of the straight line along which the second gate line slit GLS2 extends, and is located on two sides of the position where the first contact structure is located, and is located at the gate layer. A projection of the dummy channel structure DCH in a plane where the gate layer is located is located on the gate layer. In an example, the projection of the dummy channel structure DCH in a plane where the gate layer is located may be also located on the dielectric layer 103.

In some examples, the dummy channel structure DCH may be manufactured by the same process as the channel structure CH. In an example, FIG. 8B shows the dummy channel structure DCH in the memory provided by the examples of the present application. The dummy channel structure DCH may be understood with reference to the above-mentioned channel structure CH (for example, a channel layer 315 of the dummy channel structure may be understood with reference to the channel layer 215 of the channel structure CH), which is no longer repeated here.

Compared with the first gate line slit, the second gate line slit is shorter (not extending to the second region). A landing region (which may be understood as a region where the first contact structure is in contact with the first gate layer) of the first contact structure may be disposed at the position on the extension line of the second gate line slit, and the dummy channel structure in the stack structure on at least one side of the first contact structure supports the stack structure in the vicinity of the landing region, to prevent the stack structure in the vicinity of the landing region from tilting or bending.

Operation S502 is performed to form the first contact structure.

Referring to FIGs. 9A and 9B, in some examples, the method further comprises:
forming a plurality of channel structures CH penetrating through the stack structure of the first region, and a plurality of third contact structures C3 extending and connected to the different channel structures CH, referring to FIG. 9A,
wherein the first contact structure C1-1 is formed during the formation of the plurality of third contact structures C3, referring to FIG. 9B.

Referring to FIGs. 9A and 9B, in some examples, the method further comprises:
forming a select gate layer SL and a fourth contact structure C4 extending and connected to the select gate layer SL at least on the first gate layer 101-1 of the first region, referring to FIG. 9A,
wherein the first contact structure C1-1 is formed during the formation of the fourth contact structure C4, referring to FIG. 9B.

The select gate layer SL and part of the channel structures CH constitute a select transistor SG.

Referring to FIGs. 9A and 9B, in some examples, forming the first contact structure C1-1 by using the first process comprises:
forming a first contact via (not shown in FIG. 9B) extending to part of a top face of the first gate layer 101-1, and a third contact via (not shown in FIG. 9A) extending to part of a top face of the select gate layer SL/a fourth contact via (not shown in FIG. 9A) extending to part of the top face of the select gate layer SL by using a first mask layer; and filling a conductive material in the first contact via, and the third contact via/the fourth contact via respectively to form the first contact structure C1-1, and a third contact via C3/a fourth contact via C4.

In some examples, a first material layer 328 is formed on the select gate layer SL to protect the select gate layer SL. A material of the first material layer 328 includes silicon nitride.

In some examples, an opening is formed in the first material layer 328 for forming a landing region (a region where the fourth contact via C4 is in contact with the select gate layer SL) of the fourth contact via C4, a second material layer 330 covering the first material layer 328 and the select gate layer SL is formed, and the third contact via C3/the fourth contact via C4 are formed in the second material layer 330. A material of the second material layer 330 includes silicon oxide.

It may be understood that the first contact structure C1-1 and the third contact via C3 may be formed using the same mask layer, and the first contact structure C1-1 and the fourth contact via C4 may be formed using the same mask layer, and the first contact structure C1-1, the third contact via C3 and the fourth contact via C4 may also be formed using the same mask layer, which can effectively control costs.

In an example, when a range of sizes of the first contact structure C1-1, the third contact via C3 and the fourth contact via C4 in a direction perpendicular to the stacking direction is 100 nm to 500 nm, the first contact structure C1-1, the third contact via C3 and the fourth contact via C4 may be formed using the same mask layer.

While the second gate layers 101-2 to 101-N are properly led out by the second contact structures C1-2 to C1-N, the first gate layer 101-1 is properly led out by the first contact structure C1-1.

In some examples, the first contact structure C1-1 may be formed by using a separate mask layer.

In an example, when a range of size difference of the first contact structure C1-1 and the third contact via C3 in a direction perpendicular to the stacking direction is greater than 500 nm, or when a range of size difference of the first contact structure C1-1 and the fourth contact via C4 in the direction perpendicular to the stacking direction is greater than 500 nm, the first contact structure C1-1 may be formed by using a separate mask layer, to ensure that the first gate layer 101-1 is properly led out by the first contact structure C1-1.

Referring to FIGs. 6E and 9B and FIGs. 7E and 10, in some examples,
gate line slits are formed in the deck structure, and include a plurality of first gate line slits and a second gate line slit GLS2 between two adjacent ones of the first gate line slits GLS1, wherein the first gate line slits GLS1 extend from the first region to the second region, and the second gate line slit GLS2 extends from the first region to the boundary region; and
a first contact structure C1-1 is formed, which comprises:
   forming the first contact structure C1-1 at a position on the extension line of the straight line where the second gate line slit GSL2 is located and close to an end of the second gate line slit GSL2.

Compared with the first gate line slit GSL1, the second gate line slit GSL2 is shorter (not extending to the second region A2), and the landing region (which may be understood as a region where the first contact structure C1-1 is in contact with the first gate layer 101-1) of the first contact structure C1-1 is disposed at a position on the extension line EL of the second gate line slit GSL2, such that while the second gate layers 101-2 to 101-N are properly led out by the second contact structures C1-2 to C1-N, the first gate layer 101-1 is properly led out by the first contact structure C1-1.

In some examples, a material of the first contact structure C1-1 includes, but is not limited to, tungsten, cobalt, nickel, copper, aluminum, polysilicon, doped silicon, silicides, nitrides or any combination thereof. In an example, the material of the first contact structure C1-1 may be tungsten.

Operation S503 is performed to form the second contact structure.

Referring to FIGs. 6E, 9D and 7E, in some examples, the corresponding dielectric layer 103 of the stack structure in the second region A2 is located between two adjacent ones of the first gate line slits GLS1, and the corresponding gate layers (including the first gate layer 101-1 and the second gate layers 101-2 to 101-N) of the stack structure in the second region A2 are each located between the dielectric layer and the corresponding first gate line slit GLS1;
second contact structures C1-2 to C1-N are formed, which comprises:
forming the second contact structures C1-2 to C1-N between the extension line EL of the straight line where the second gate line slit GLS2 is located and two of the first gate line slits GLS1, wherein part of the second contact structures C1-2 to C1-N between the extension line EL and one of the first gate line slits GLS1 and the other part of the second contact structures C1-2 to C1-N between the extension line EL and the other one of the first gate line slits GLS1 are in juxtaposition and in a staggered arrangement;
a side of the second contact structures C1-2 to C1-N close to the first gate line slit GSL1 is connected with the respective second gate layers 101-2 to 101-N;
here, N is a natural number greater than or equal to 2.

The second contact structures C1-2 to C1-N are uniformly distributed on two sides close to the first gate line slit GSL1, which can increase the process window of forming the second contact structures C1-2 to C1-N, and the second gate layers 101-2 to 101-N are properly led out by the second contact structures C1-2 to C1-N.

Referring to FIGs. 6D to 6E, or referring to FIGs. 7D to 7E, in some examples, the dielectric layer 103 comprises a first dielectric layer and a plurality of second dielectric layers on a side of the first dielectric layer;
forming the gate layer (including the first gate layer 101-1 and the second gate layer 101-2 to 101-N) and the plurality of second contact structures C1-2 to C1-N comprises: forming a plurality of second contact vias in the second region, wherein the plurality of second contact vias extend to the second dielectric layers of different layers respectively;
depositing a conductive material in gate slits of the first region, gate slits of the boundary region and the second region, and the plurality of second contact vias, to obtain the gate layer and the plurality of second contact structures; or
depositing a conductive material in gate slits of the first region, and gate slits of the boundary region and the second region, to obtain the gate layer; and depositing a conductive material in the plurality of second contact vias, to obtain the plurality of second contact structures.

The first dielectric layer is located on the same layer as the first gate layer, and the plurality of second dielectric layers on a side of the first dielectric layer are located on the same layer as the respective second gate layers.

In an example, referring to FIG. 6D, after obtaining the space SP1, the space SP2 and the space SP3 that are interconnected together, or during the formation of the space SP1, the space SP2 and the space SP3, the filling material in the plurality of second contact vias is removed to obtain a plurality of second contact vias interconnected together with the space SP1, the space SP2 and the space SP3. Referring to FIG. 6E, the conductive material is deposited in the gate slits of the first region, the gate slits of the boundary region and the second region, and the plurality of second contact vias, to obtain the gate layer and the plurality of second contact structures C1-2 to C1-N.

As such, the plurality of second contact structures and the respective gate layers are formed integrally, which may save process operations.

In an example, referring to FIG. 6D, after obtaining the space SP1, the space SP2 and the space SP3 that are interconnected together, the filling material in the plurality of second contact vias remains; and after filling the conductive material at the space SP1, the space SP2 and the space SP3 that are interconnected together to obtain the first gate layer and the second gate layers, the filling material in the plurality of second contact vias is removed to obtain the plurality of second contact vias.

Referring to FIG. 6E, the conductive material is deposited in the plurality of second contact vias to obtain the plurality of second contact structures C1-2 to C1-N.

In some examples, a material of the plurality of second contact structures C1-2 to C1-N includes, but is not limited to, tungsten, cobalt, nickel, copper, aluminum, polysilicon, doped silicon, silicides, nitrides or any combination thereof. In an example, the material of the plurality of second contact structures C1-2 to C1-N may be tungsten.

As such, the plurality of second contact structures and the respective gate layers are formed in steps, which can reduce the process difficulty.

FIGs. 11A to 11F are schematic cross-sectional views of a manufacturing process of a second contact structure of a third semiconductor structure provided by examples of the present application. Here, FIG. 11F may be understood as a schematic diagram of the C-C cross-section of the second region of the semiconductor structure of FIG. 6E.

Referring to FIGs. 11A to 11F, in some examples, forming the plurality of second contact vias in the second region comprises:
forming a plurality of first contact vias (taking the first contact vias CTH1-2 to CTH1-3 as an example) penetrating through the deck structure in the second region A2, referring to FIG. 11A, wherein the plurality of first contact vias extend to the insulation layers 102 over the second dielectric layers of different layers respectively;
forming a spacing material layer 324' at least covering sidewalls and bottom faces of the plurality of first contact vias, referring to FIG. 11B; and
removing the spacing material layer 324' at bottoms of the plurality of first contact vias and the insulation layers 102 sequentially to obtain the second contact vias (taking the second contact vias CTH1-21 to CTH1-31 as an example), referring to FIGs. 11C to 11D, wherein bottom faces of the second contact vias expose the second dielectric layers of the corresponding layers.

In some examples, the second contact structure comprises a lead-out portion 301 and a connection portion 302, and forming the second contact structure (taking the second contact structures C1-2 to C1-3 as an example) comprises:
removing part of the second dielectric layer on the bottom face of the second contact via, referring to FIG. 11D; and
forming a conductive material at a position where the second dielectric layer is removed, and at a sidewall of the second contact via, referring to FIG. 11E, wherein the conductive material at the position where the second dielectric layer is removed forms the connection portion 302, and the conductive material at the sidewall of the second contact via forms the lead-out portion 301.

In some examples, a material of the lead-out portion 301 and a material of the connection portion 302 include, but are not limited to, tungsten, cobalt, nickel, copper, aluminum, polysilicon, doped silicon, silicides, nitrides or any combination thereof. In an example, the material of the lead-out portion 301 and the material of the connection portion 302 may be tungsten.

Here, a space SP302 is obtained at the position where part of the second dielectric layer on the bottom face of the second contact via is removed, and the space SP302 (referring to FIG. 11D) is connected together with the second contact vias CTH1-21 to CTH1-31 (referring to FIG. 11C). The lead-out portion 301 and the connection portion 302 (referring to FIG. 11E) obtained are formed integrally.

As such, the connection portion 302 of the second contact structure is in contact with the respective second gate layer. In an example, referring to FIG. 10D, the connection portion 302 of the second contact structure C1-N is in contact with the respective second gate layer 101-N.

The semiconductor structure manufactured by the manufacturing method of the semiconductor structure provided by the examples of the present application is similar to the semiconductor structure in the above examples. The technical features not disclosed in detail in the examples of the present application may be understood with reference to the above examples, and are no longer repeated here.

According to a third aspect of the present application, a memory system is provided, which comprises:
a semiconductor structure which is the semiconductor structure of any one of the above examples; and
a controller connected with the semiconductor structure.

Here, the semiconductor structure may be a memory, or a part of the memory. A detailed description is made below by taking the semiconductor structure being a memory as an example.

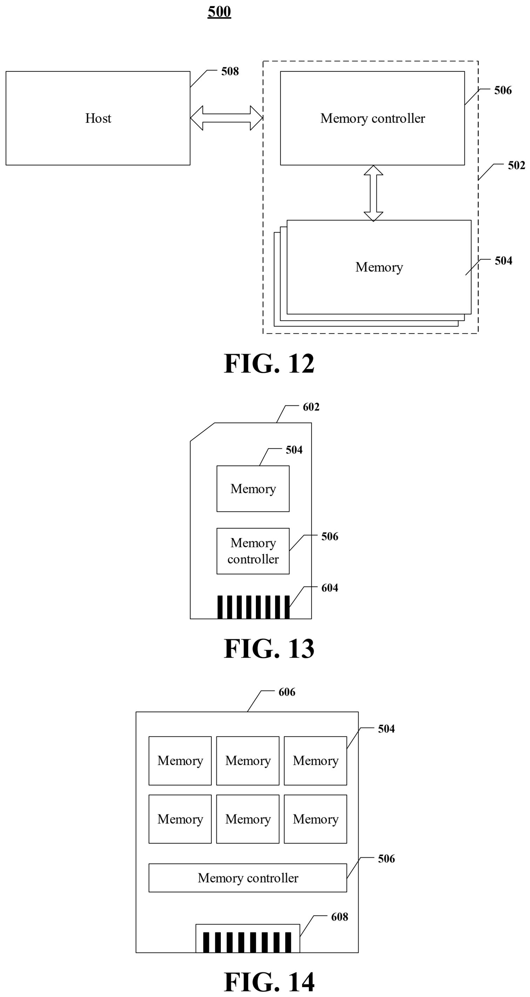

FIG. 12 shows a block diagram of an example system 500 having a memory according to some aspects of the present application. The system 500 may be a mobile phone, a desktop computer, a laptop computer, a tablet computer, a vehicle computer, a gaming console, a printer, a positioning apparatus, a wearable electronic apparatus, a smart sensor, a virtual reality (VR) apparatus, an augmented reality (AR) apparatus, or any other suitable electronic apparatuses having memories therein. As shown in FIG. 12, the system 500 may comprise a host 508 and a memory system 502, wherein the memory system 502 has one or more memories 504 and a memory controller 506. The host 508 may be a processor (e.g., a central processing unit (CPU)) or a system on chip (SOC) (e.g., an application processor (AP)) of an electronic apparatus. The host 508 may be configured to send or receive data to or from the memories 504.

The memories 504 may be any memory in the present application. As disclosed below in detail, the memories 504, e.g., NAND flash memories (such as, three-dimensional (3D) NAND flash memories), may have a reduced leakage current from a drive transistor (e.g., a string driver) coupled to unselected word lines during erase operations, which allows for further reduction of the size of the drive transistor.

According to some implementations, the memory controller 506 is coupled to the memories 504 and the host 508, and configured to control the memories 504. The memory controller 506 can manage the data stored in the memories 504 and communicate with the host 508. In some implementations, the memory controller 506 is designed for operating in a low duty-cycle environment such as Secure Digital (SD) cards, Compact Flash (CF) cards, Universal Serial Bus (USB) flash drives, or other media for use in electronic apparatuses, such as personal computers, digital cameras, mobile phones, etc. In some implementations, the memory controller 506 is designed for operating in high duty-cycle environment SSDs or embedded Multi-Media Cards (eMMCs) used as data memories for mobile apparatuses, such as smartphones, tablet computers, laptop computers, etc., and enterprise memory arrays.

The memory controller 506 may be configured to control operations of the memories 504, such as read, erase, and program operations. The memory controller 506 may be further configured to manage various functions with respect to data stored or to be stored in the memories 504, including, but not limited to bad-block management, garbage collection, logical-to-physical address conversion, wear leveling, etc. In some implementations, the memory controller 506 is further configured to process error correction codes (ECCs) with respect to the data read from or written to the memories 504. The memory controller 506 may further perform any other suitable functions as well, for example, formatting the memories 504. The memory controller 506 may communicate with an external apparatus (e.g., the host 508) according to a particular communication protocol. For example, the memory controller 506 may communicate with the external apparatus through at least one of various interface protocols, such as a USB protocol, a MMC protocol, a Peripheral Component Interconnection (PCI) protocol, a PCI-Express (PCI-E) protocol, an Advanced Technology Attachment (ATA) protocol, a Serial-ATA protocol, a Parallel-ATA protocol, a Small Computer Small Interface (SCSI) protocol, an Enhanced Small Disk Interface (ESDI) protocol, an Integrated Drive Electronics (IDE) protocol, a Firewire protocol, etc.

The memory controller 506 and one or more memories 504 can be integrated into various types of storage apparatuses, for example, be included in the same package, such as a Universal Flash Storage (UFS) package or an eMMC package. That is, the memory system 502 can be implemented and packaged into different types of electronic end products.

In one example as shown in FIG. 13, the memory controller 506 and a single memory 504 may be integrated into a memory card 602. The memory card 602 may include a PC card (PCMCIA, Personal Computer Memory Card International Association), a CF card, a Smart Media (SM) card, a memory stick, a Multimedia card (MMC, RS-MMC, MMCmicro), an SD card (SD, miniSD, microSD, SDHC), a UFS, etc. The memory card 602 may further comprise a memory card connector 604 coupling the memory card 602 with a host (e.g., the host 508 in FIG. 12).

In another example as shown in FIG. 14, the memory controller 506, and multiple memories 504 may be integrated into an SSD 606. The SSD 606 may further include an SSD connector 608 coupling the SSD 606 with a host (e.g., the host 508 in FIG. 12). In some implementations, at least one of the storage capacity or the operation speed of the SSD 606 are greater than at least one of the storage capacity or the operation speed of the memory card 602 (as shown in FIG. 13).

The features disclosed in several method or device examples as provided by the present application may be combined freely to obtain new method or device examples in case of no conflicts.

Those of ordinary skill in the art may understand that the above implementations are particular examples for implementing the present application, and in practical applications, various changes may be made in form and in detail without departing from the spirit and scope of the present application. Within the technical scope disclosed by the present application, any person skilled in the art may readily conceive that variations or replacements should be encompassed within the protection scope of the present application.

### Industrial applicability

Examples of the present application provide a semiconductor structure and a manufacturing method thereof, and a memory system. A first contact structure and a second contact structure of the semiconductor structure are disposed separately, such that the first contact structure is disposed in a third region, and the second contact structure is disposed in a second region. Moreover, sizes of the first contact structure and the second contact structure in a direction perpendicular to a stacking direction are set as different, such that a second gate layer is properly led out by the second contact structure, and a first gate layer is properly led out by the first contact structure.

## Claims

1. A semiconductor structure, comprising:
a stack structure comprising a first region, a second region and a boundary region between the first region and the second region, wherein the stack structure comprises gate layers and insulation layers that are stacked alternately, and the gate layers include a first gate layer and a plurality of second gate layers on a side of the first gate layer;
a first contact structure in the boundary region, extending and connected to the first gate layer; and
a plurality of second contact structures in the second region, extending and connected to the second gate layers of different layers respectively,
wherein a size of the first contact structure in a direction perpendicular to a stacking direction of the stack structure is different from sizes of the second contact structures in the direction perpendicular to the stacking direction.

2. The semiconductor structure of claim 1, wherein dielectric layers are further disposed on planes where the corresponding gate layers of the stack structure of the second region are located;
a periphery of a position where the first contact structure is located corresponds to the gate layers and the insulation layers that are stacked alternately; a part of peripheries of positions where the second contact structures are located corresponds to the gate layers and the insulation layers that are stacked alternately, and the other part corresponds to the dielectric layers and the insulation layers that are stacked alternately.

3. The semiconductor structure of claim 1 or 2, further comprising:
a plurality of channel structures penetrating through the stack structure of the first region; and
a plurality of third contact structures in the first region, extending and connected to different ones of the channel structures respectively,
wherein cross-sectional shapes of the first contact structure and the third contact structures in a plane perpendicular to the stacking direction are the same.

4. The semiconductor structure of any one of claims 1 to 3, further comprising:
a select gate layer on the first gate layer; and
a fourth contact structure in the first region, extending and connected to the select gate layer,
wherein cross-sectional shapes of the first contact structure and the fourth contact structure in the plane perpendicular to the stacking direction are the same.

5. The semiconductor structure of claim 3 or 4, wherein a top face of the first contact structure is substantially flush with a top face of at least one of the third contact structure or the fourth contact structure.

6. The semiconductor structure of claim 3 or 4, wherein the size of the first contact structure in the direction perpendicular to the stacking direction is less than the sizes of the second contact structures in the direction perpendicular to the stacking direction.

7. The semiconductor structure of claim 2, wherein the semiconductor structure further comprises: a plurality of first gate line slit structures and a second gate line slit structure between two adjacent ones of the first gate line slit structures, the first gate line slit structures extending from the first region to the second region, and the second gate line slit structure extending from the first region to the boundary region,
wherein the first contact structure is located on an extension line of a straight line where the second gate line slit structure is located, and is located at a position close to an end of the second gate line slit structure.

8. The semiconductor structure of claim 7, wherein the corresponding dielectric layer of the stack structure in the second region is located between two adjacent ones of the first gate line slit structures, and the corresponding gate layers of the stack structure in the second region are each located between the dielectric layer and a respective first gate line slit structure; the second contact structure is located between the extension line of the straight line where the second gate line slit is located and two of the first gate line slit structures; part of the second contact structure between the extension line and one of the first gate line slit structures and the other part of the second contact structure between the extension line and the other one of the first gate line slit structures are in juxtaposition and in a staggered arrangement; and
a side of the second contact structure close to the first gate line slit structure is connected with the respective second gate layer.

9. The semiconductor structure of claim 7 or 8, wherein dielectric layers are further disposed on planes where the corresponding gate layers of the stack structure of the boundary region are located; and the gate layer and the dielectric layer located between the first gate line slit structure and the second gate line slit structure in the boundary region have an interface;
the interface is located between the first contact structure and the second region; the semiconductor structure further comprises at least one dummy channel structure that is located on the extension line of the straight line along which the second gate line slit extends and is located on at least one side of the first contact structure; or
the interface is located between the first contact structure and the first region; and gate layers and insulation layers that are stacked alternately are around the first contact structure along the extension line of the straight line along which the second gate line slit extends.

10. The semiconductor structure of claim 1, wherein,
the first contact structure extends to the first gate layer along the stacking direction of the stack structure;
each of the second contact structures comprises a lead-out portion and a connection portion, wherein the lead-out portion extends in a direction parallel to the stacking direction of the stack structure, and one end of the lead-out portion is connected with part of a top face of the connection portion; and the connection portion extends along a direction perpendicular to the stacking direction and is connected to a corresponding second gate layer.

11. A manufacturing method of a semiconductor structure, comprising:
forming a stack structure comprising a first region, a second region and a boundary region between the first region and the second region, wherein the stack structure comprises gate layers and insulation layers that are stacked alternately, and the gate layers include a first gate layer and a plurality of second gate layers disposed on a side of the first gate layer;
forming a first contact structure in the boundary region by using a first process, the first contact structure extending and connecting to the first gate layer; and
forming a plurality of second contact structures in the second region by using a second process, the plurality of second contact structures extending and connecting to the second gate layers of different layers respectively,
wherein the first process is different from the second process.

12. The manufacturing method of claim 11, further comprising:
forming a plurality of channel structures penetrating through the stack structure of the first region, and a plurality of third contact structures extending and connected to different ones of the channel structures,
wherein the first contact structure is formed during formation of the plurality of third contact structures.

13. The manufacturing method of claim 11 or 12, further comprising:
forming a select gate layer and a fourth contact structure extending and connected to the select gate layer at least on the first gate layer of the first region,
wherein the first contact structure is formed during formation of the fourth contact structure.

14. The manufacturing method of claim 12 or 13, wherein forming the first contact structure by using the first process comprises:
forming a first contact via extending to part of a top face of the first gate layer, and a third contact via extending to part of a top face of the select gate layer/a fourth contact via extending to part of the top face of the select gate layer by using a first mask layer, wherein a conductive material is filled in the first contact via, and the third contact via/the fourth contact via respectively to form the first contact structure, and the third contact via/the fourth contact via.

15. The manufacturing method of claim 11, wherein forming the stack structure comprises:
forming a deck structure comprising a first region, a second region and a boundary region between the first region and the second region, wherein the deck structure comprises dielectric layers and insulation layers that are stacked alternately; and
replacing the dielectric layers of the first region, at least part of the dielectric layers of the boundary region, and at least part of the dielectric layers of the second region with the gate layers, to obtain the stack structure.

16. The manufacturing method of claim 15, wherein,
gate line slits are formed in the deck structure, wherein the gate line slits include a plurality of first gate line slits and a second gate line slit between two adjacent ones of the first gate line slits; the first gate line slits extend from the first region to the second region; and the second gate line slit extends from the first region to the boundary region; and
the forming the first contact structure comprises:
forming the first contact structure at a position on an extension line of a straight line where the second gate line slit is located and close to an end of the second gate line slit.

17. The manufacturing method of claim 16, wherein the corresponding dielectric layer of the stack structure in the second region is located between two adjacent ones of the first gate line slits, and the corresponding gate layers of the stack structure in the second region are each located between the dielectric layer and the respective first gate line slit;
the forming the second contact structure comprises:
forming the second contact structure between the extension line of the straight line where the second gate line slit is located and two of the first gate line slits, wherein part of the second contact structure between the extension line and one of the first gate line slits and the other part of the second contact structure between the extension line and the other one of the first gate line slits are in juxtaposition and in a staggered arrangement; and
a side of the second contact structure close to the first gate line slit is connected with the respective second gate layer.

18. The manufacturing method of claim 16 or 17, wherein removing part of the dielectric layers of the boundary region comprises:
forming a second mask layer covering the first region; and removing part of the dielectric layers of the boundary region together with part of the dielectric layers of the second region by using the second gate line slit of the boundary region and the first gate line slits of the boundary region and the second region; or
forming a third mask layer covering the second region; and removing part of the dielectric layers of the boundary region together with the dielectric layers of the first region, by using the first gate line slits of the first region and the boundary region and the second gate line slit of the first region and the boundary region.

19. The manufacturing method of claim 18, wherein part of the dielectric layers of the boundary region and the dielectric layers of the first region are removed together; and the manufacturing method further comprises:
before removing part of the dielectric layers of the boundary region, forming at least one dummy channel structure around a position where the first contact structure is located, wherein the dummy channel structure is located on the extension line of the straight line along which the second gate line slit extends, and is located on at least one side of the position where the first contact structure is located.

20. A memory system, comprising:
the semiconductor structure of any one of claims 1-10; and
a controller connected with the semiconductor structure.
